**Europäisches Patentamt**

**European Patent Office**

**Office européen des brevets**

(19)

(11) Veröffentlichungsnummer: **0 240 578**
**A1**

## (12) EUROPÄISCHE PATENTANMELDUNG

(21) Anmeldenummer: **86104357.8**

(22) Anmeldetag: **29.03.86**

(51) Int. Cl.⁴: **G01R 31/28** , **G06F 11/26** , **G11C 19/00**

(43) Veröffentlichungstag der Anmeldung:
**14.10.87 Patentblatt 87/42**

(84) Benannte Vertragsstaaten:
**DE FR GB IT**

(71) Anmelder: **IBM DEUTSCHLAND GMBH**
**Pascalstrasse 100**
**D-7000 Stuttgart 80(DE)**

(84) **DE**

(71) Anmelder: **International Business Machines**
**Corporation**
**Old Orchard Road**
**Armonk, N.Y. 10504(US)**

(84) **FR GB IT**

(72) Erfinder: **Blum, Arnold, Dipl.-Ing.**
**Finkenweg 16**
**D-7261 Gechingen(DE)**

(74) Vertreter: **Jost, Ottokarl, Dipl.-Ing.**
**Schönaicher Strasse 220**
**D-7030 Böblingen(DE)**

(54) **Anordnung und Verfahren für externe Testzugriffe auf die chipinternen funktionellen Speicherelemente hochintegrierter logischer Netzwerke.**

(57) Bei einigen sehr kostengünstigen Zugriffsmechanismen für das Testen ultrahochintegrierter Logikchips steigt jedoch leider mit der Anzahl der chipinternen Speicherelemente die Höhe der fan-in - und fan-out -Werte sowie der Steuerschaltkreisaufwand und die benötigte Testzugriffszeit zum Ein-und Auslesen aller internen Speicherelemente sehr stark an.

Eine Lösung dieses Problems kann durch ein gestaffeltes Kaskaden-Schiebekonzept erreicht werden, bei dem eine große Anzahl von einzelnen Kaskaden-Schiebekettengruppen gestaffelt angeordnet werden, indem die jeweils letzten funktionellen Latche LT8 der einzelnen Kaskaden-Schiebekettengruppen KSGi unabhängig zu einer konventionellen Schiebekette (Schieberegister), zu einer Imaginär-Schiebekette oder zu anderen Schiebe-oder Zugriffsschaltungen verbunden werden. Diese neue Kette wird als Kaskaden-Schiebekette CH 0 bezeichnet. Mit Hilfe der Kaskaden-Schiebekette CH 0 können die jeweils letzten Latche LT 8 einer Schiebekettengruppe direkt ohne Benutzung der einzelnen Schie-bekettengruppen gelesen oder gesetzt werden. Hierdurch wird auch das Symmetrieproblem gelöst, welches beim Hineinschieben der Information in die individuellen Kaskaden-Schiebekettengruppen auftritt, und die einzelnen Kaskaden-Schiebekettengruppen können voll symmetrisch betrieben werden.

Um auch für die jeweils ersten Latche LT1 einen direkten Zugang von außerhalb des Chips zu - schaffen, sind ihre Eingänge unmittelbar mit den entsprechenden Ausgängen der letzten Latche LT8 verbunden. Die Kaskaden-Schiebekette CH 0 kann ferner separat mittels derjenigen Schiebetakte betrieben werden, die von den normalen Schiebetaktfolgen SH-CL1 und SH-CL2 mit Hilfe eines zusätzliches Codewortes der Teststeuersignale TG0 und TG1 abgeleitet werden.

FIG. 6

1a

## Anordnung und Verfahren für externe Testzugriffe auf die chipinternen funktionellen Speicherelemente hochintegrierter logischer Netzwerke.

Die Erfindung betrifft Anordnungen und Verfahren für externe Testzugriffe nach dem Oberbegriff der Patentansprüche 1, 5 und 6.

Das Testen von hochverdichteten Logik-und Speicherschaltkreisen auf Chips, aus denen elektronische Steuerungen, Prozessoren und Datenverarbeitungsanlagen aufgebaut sind, beruht sehr wesentlich auf der Zugänglichkeit (Einstellbarkeit, Beobachtbarkeit) der Gesamtheit aller Speicherelemente (Verriegelungsschaltungen) auf dem Chip.

Zeitgemäße Systemarchitekturen und Logikstrukturen machen daher oft Gebrauch von einem sogenannten LSSD-Entwurfsprinzip (LSSD = Level Sensitive Scan Design), nach dem sich beispielsweise ein Logik-Subsystem signalpegelsensitiv verhält. Dies ist dann der Fall, wenn die Antwort im eingeschwungenen Zustand auf eine Eingangssignaländerung von den Minimalwerten der Schaltkreis-und Leitungsverzögerungen innerhalb des Logik-Subsystems unabhängig ist (vgl. "A Logic Design Structure for LSI Testability" von E.B. Eichelberger - Proceedings of the Design Automation Conference No. 14, 20-22 Juni 1977, New Orleans, Lousiana, Seiten 462 bis 468).

Basierend auf diesem LSSD-Entwurfsprinzip wird die Einstellbarkeit und Beobachtbarkeit der Gesamtheit aller Speicherelemente dadurch ermöglicht, daß die einen Bestandteil der Logik bildenden Master-/Slave-Speicher elemente im Testbetrieb zu einer oder mehreren Schieberegisterketten zusammenschaltbar sind, über die Testmuster in die Tiefe der Logik hinein-und Testergebnisdaten, welche die Antwort der Logiknetze auf diese Testmuster darstellen, hinausgeschoben werden.

Der Grund für ein solches Vorgehen liegt darin, daß sequentielle Logiknetzwerke außerordentlich - schwierig zu testen sind. Durch die Aufteilung von sequentiellen Logiknetzwerken in zwei Bestandteile, nämlich

1. in die internen Speicherelemente (ausgenommen jedoch Speichermatrizen) und

2. in die von den internen Speicherelemnten betriebenen kombinatorischen Netze, ist das Testen sequentieller Logiknetzwerke praktisch erst möglich.

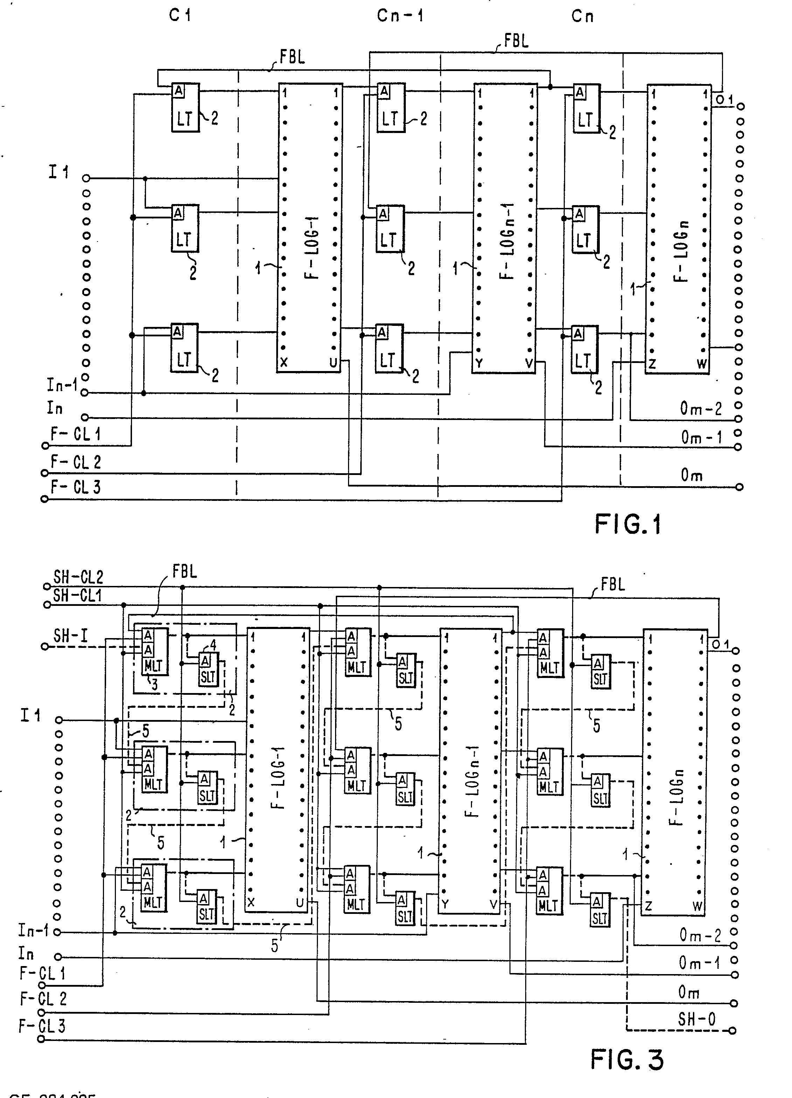

Einen Ausschnitt aus einem Logiknetzwerk, das die erwähnte Aufteilung in die zwei Bestandteile erkennenläßt, zeigt Figur 1. Die kombinatorischen Logiknetze (F-Log 1 bis F-Log n) 1, welche die Logikfunktionen, bzw. Teillogikfunktionen ausführen, sind über interne Speicherelemente (LT) 2 miteinander verkoppelt. Die Speicherelemente 2 sind ihrer Struktur nach Verriegelungsschaltungen, oder genauer gesagt, Polarity-Hold-Latche, die über einen Eingang und einen Ausgang verfügen, wobei der Eingang über ein UND-Glied (A) mit einer Daten-und einer Taktleitung verbunden ist.

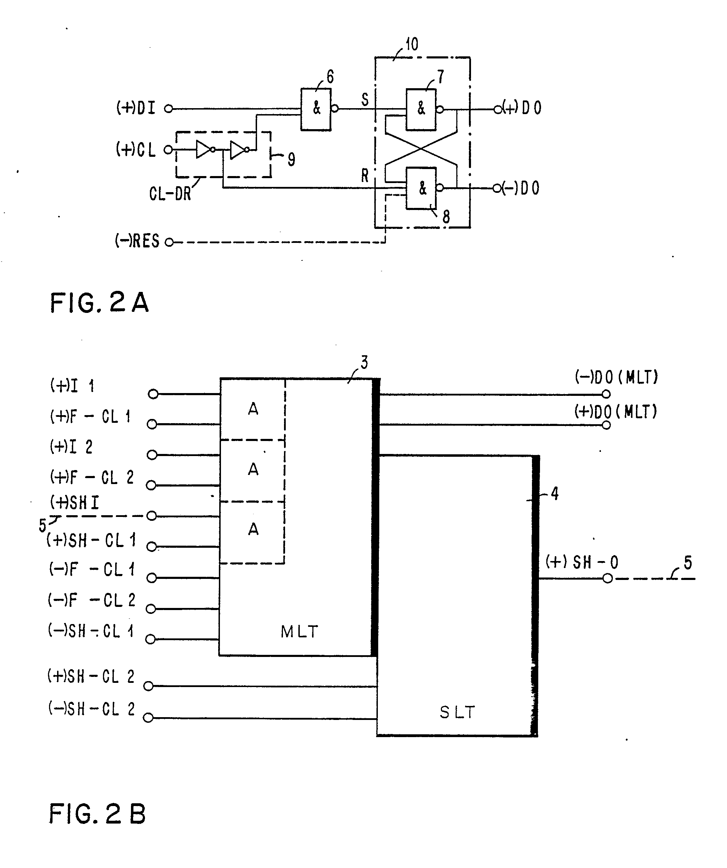

Ein Ausführungsbeispiel eines Polarity-Hold-Latches ist in Figur 2A gezeigt. Der Dateneingang +DI und der Takteingang +CL, letzterer allerdings über einen Takttreiber (CL-DR) 9, sind mit einem NAND-Glied 6 verbunden. Der Takttreiber 9 besteht aus einem Phasenteilerschaltkreis mit zwei Stufen, deren jede eine Verzögerung $\Delta t$ hat. Der Ausgang des NAND-Gliedes 6 ist mit dem Einstelleingang (S) und der Phasenteilerabgriff mit dem Rückstelleingang (R) des eigentlichen Speichergliedes 10, bestehend aus zwei kreuzgekoppelten NAND-Gliedern 7 und 8, verbunden. Das Speicherglied 10 verfügt über einen Datenausgang +DO sowie über einen invertierten Datenausgang -DO. Ferner sieht die Schaltung einen Rückstelleingang -RES vor, der zu dem NAND-Glied 8 geführt ist. In den Fig. 2A,B ist auch die Polarität (-, +) der Signale dargestellt, welche die verwendete Technologie erfordert. Fig. 2B zeigt eine Master-/Slave-Darstellung.

Die Daten werden einem Chip, das solche kombinatorische Logiknetze enthält, über externe Eingänge I1 bis In zugeführt und über externe Ausgänge O1 bis On entnommen. Funktionsbedingt ist die Logik so strukturiert, daß die Speicherglieder 2 der ersten Reihe C1 nur ein Teilnetz, nämlich das funktionelle kombinatorische Logiknetz F-LOG1, die Speicherglieder 2 der Spalte Cn-1 das funktionelle kombinatorische Logiknetz F-LOG n-1 und die Speicherglieder 2 der letzten Spalte Cn das letzte funktionelle kombinatorische Logiknetz F-LOGn auf dem Chip bedienen.

Die funktionellen kombinatorischen Logiknetze der zweiten bis n-ten Ebene haben sowohl externe Eingänge, nämlich In-1 bzw. In, als auch interne Eingänge 1 bis Y-1 bzw. 1 bis Z-2, die ebenfalls über Speicherglieder 2 mit internen Ausgängen von funktionellen kombinatorischen Netzen verbunden sind. Ebenso verfügt eine derartige Schaltungsanordnung auch über Speicherglieder 2, die über Rückkopplungsleitungen FBL mit den Ausg ängen nachfolgender funktioneller kombinatorischer Logiknetze verbunden sind.

Gesteuert wird die Datenübernahme der funktionellen kombinatorischen Logiknetze durch einander nicht überlappende funktionelle Systemtake F-CL1, F-CL2 und F-CL3. Die funktionellen Systemtakte sind zudem voneinander unabhängig.

Um die funktionellen kombinatorischen Netze auch physikalisch testen zu können, müssen die Testmuster an deren Eingänge angelegt werden können. Die Reaktionen (Ergebnisse) dieser funktionalen kombinatorischen Logiknetze auf die angelegten Testmuster müssen an ihren Ausgängen zugreifbar sein, um sie mit den zu erwartenden Sollwerten vergleichen zu können. Da die meisten Eingangs-und Ausgangsverbindungen der Logiknetze über die externen Chipanschlüsse nicht zugreifbar sind, wird nach dem LSSD-Entwurfprinzip jedem internen Latch ein Hilfslatch zugeordnet und auf dem Chip implementiert (Fig. 2B). Die Veränderung des Polarity-Hold-Latches (LT) in Figur 1 zur Einführung der Schiebefähigkeit bedingt im wesentlichen ein Hinzufügen eines getakteten Eingangsgatters zum Latch sowie die Implementierung eines Hilfslatches, des bereits erwähnten Slave-Latches. Das erste, durch das zusätzliche getaktete Eingangsgatter für die Schiebefunktion erweiterte Latch wird Master-Latch (MLT) genannt. Das Slave-Latch (SLT) dient als Zwischenspeicherelement zur Pufferung des Datenbits während des Schiebevorgangs von einer Schieberegisterstufe (SRL) zur nächsten. Die physikalische Kombination dieser beiden Latche stellt funktionell ein einziges internes Speicherelement LT in Fig. 1 dar, das gleichzeitig die zuvor erwähnte Schieberegisterstufe SRL umfaßt, deren symbolische Darstellung Figur 2B zeigt. Im Testbetrieb werden dann alle Latche auf dem Chip zu einer oder mehreren Schiebeketten verbunden.

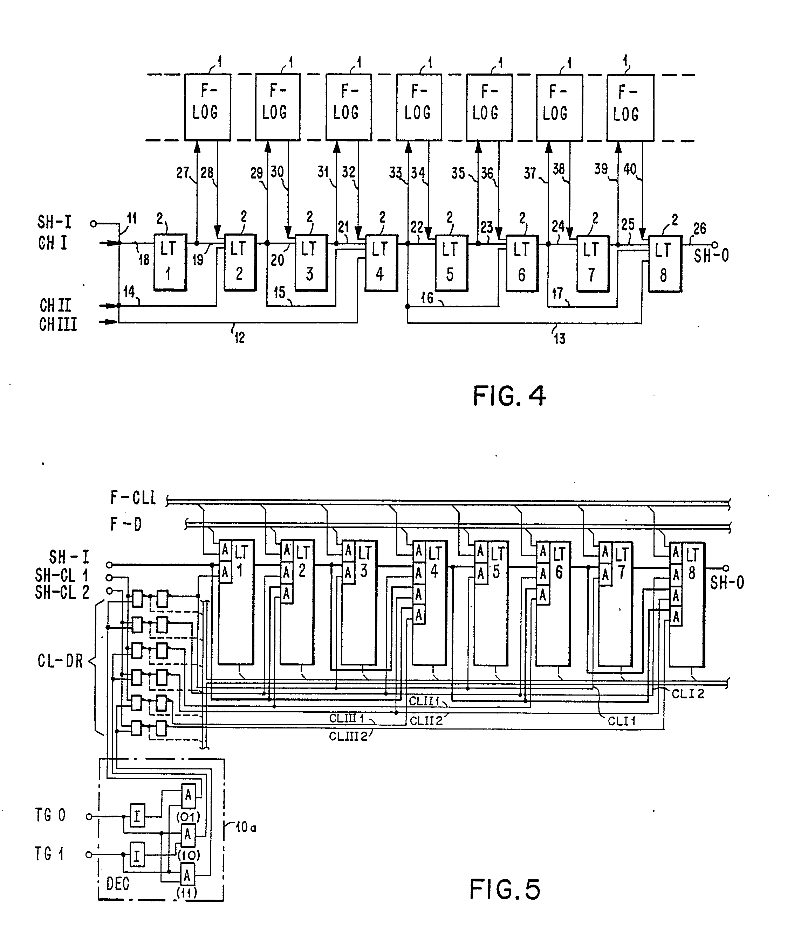

Eine Schiebekette benötigt im einfachsten Falle nur vier externe Anschlüsse, nämlich einen Dateneingang SH-I, einen Datenausgang SH-0 und Anschlüsse für jeweils einen Schiebetakt SH-CL1 und SH-CL2. Die in Figur 1 dargestellte Logikstruktur erhält auf diese Weise die in Figur 3 abgebildete modifizierte Struktur.

Wie die Darstellung eines Speichergliedes 2 in Figur 3 zeigt, bestehen diese aus einem Master-Latch (MLT) 3 mit zwei UND-Eingängen (A) und einem Slave-Latch (SLT) 4. Ferner sind hinzugekommen ein Ausgang SH-0 für die Schiebedaten, die dann beispielsweise zum Schiebeeingang einer nachfolgenden Logikstruktur weitergeleitet werden können.

Dieses ist in Fig. 2B als Leitung 5 dargestellt, welche die Schieberegisterstufen (LT = SRL) zu einer Kette zusammenschaltet, indem sie den Schiebedatenausgang SH-0 einer jeweiligen Stufe mit dem Schiebedateneingang SH-I der jeweils nachfolgenden Stufe verbindet.

Grundsätzlich können auch die Slave-Latche als mit dem Verschiebetakt SH-CL 2 betriebene einfache Polarity-Hold-Latche implementiert werden. Es können aber auch beide, sowohl das Master-Latch, als auch das Slave-Latch als störsignalfreie D-Latche (bekannt auch als D-Flip-Flops) realisiert werden.

Da das Slave-Latch und das mit SH-CL 1 getaktete Eingangsgatter des (Master)-Polarity-Hold-Latches einen bei der funktionellen Chip-Operation normalerweise nicht benutzten Testschaltungsaufwand darstellt, ergibt sich damit der Nachteil eines höheren Silizium-Flächenbedarfs für die Speicherglieder 2, der bei der üblicher weise sehr hohen Zahl dieser Speicherglieder auf den in Höchstintegrationstechnik (VLSI) hergestellten Chips sich auf beträchtliche Werte summiert.

Es mangelt daher nicht an Vorschlägen, die darauf abzielen, ökonomischer mit der Siliziumfläche von höchstintegrierten Chips, insbesondere Logik-Chips, umzugehen. Fast alle dieser Lösungsvorschläge gehen davon aus, Schieberegister oder Schieberegisterketten nur aus Master-Latchen aufzubauen und auf die Slave-Latche, welche die Funktion eines Zwischenspeichers während der Schiebeoperation haben, ganz zu verzichten. Da aber bei der Zusammenschaltung von Polarity-Hold-Master-Latchen die Zwischenspeicherfunktion fehlt, würde, wenn man keine besonderen Maßnahmen ergreift, 50 % der Information verlorengehen, was bei der Fehlerprüfung von höchstintegrierten Chips nicht tolerierbar ist.

Ein Vorschlag, der einen solchen Informationsverlust vermeidet und trotzdem keine zusätzliche Siliziumfläche für die Zwischenspeicher-Slave-Latche benötigt, ist im IBM TDB, September 1980, Seiten 1504 bis 1505 beschrieben. Es werden hier für die Prüfung von höchst integrierten LogikChips Schiebeketten gebildet, die nur aus funktionellen Polarity-Hold-(Master-) Latchen bestehen. Die Zusammenschaltung der Master-Latche erfolgt jedoch so, daß eine Stufe eines solchen Schieberegisters aus zwei "Master"-Latchen besteht, von denen das jeweils nachgeschaltete die Funktion eines Slave-Latches, also des 1-Bit Zwischenspeichers übernimmt. Eine solche Schieberegisterstruktur läßt sich in Logik-Chips, die nach dem signalpegelabhängigen Entwurfsprinzip implementiert wurden, immer dann bilden, wenn sich auf dem Chip - und das ist in aller Regel der Fall - Logikgruppen mit zugehörigen funktionellen "Master"-Latchen finden lassen, die zeitlich voneinander unabhängig sind. Man braucht somit mindestens zwei zeitlich voneinander unabhängige Gruppen. Wenn also zum Zeitpunkt T1 eine Gruppe I für Testzwecke beaufschlagt wird und erst später zu einem Zeitpunkt T2 eine zweite Gruppe II für Testzwecke benutzt werden soll, dann können Master-Latche der Gruppe II zur Zeit T1 als Slave-Latche (oder umgekehrt) für eine Schieberegisterkette verwendet werden.

Ein weiterer Vorschlag ist im IBM TDB, Juli 1980, Seiten 647 und 648 beschrieben, bei dem nicht zeitlich, sondern logisch voneinander unabhängige Gruppen von Master-Latchen zu Schieberegisterketten zusammengefaßt werden, die auf eine (Zwischenspeicher)-Slave-Latch-Funktion nicht verzichten müssen, da funktionelle Master-Latche in ausreichender Zahl zur Verfügung stehen.

Des weiteren ist in der europäischen Patentschrift 0 046 499 ein Schieberegister für Prüf-und Testzwecke beschrieben, das Bestandteil eines Logik-oder Speicherhalbleiter-Chips in hochintegrierter Technik ist. Das Schieberegister wird mit A-/B-Takten (entsprechend den schon erwähnten Takten SH-CL1 und SH-CL2) fortgeschaltet, und dessen einzelne Stufen bestehen aus jeweils einer Hauptverriegelungsschaltung (Master-Latch) und einer Hilfsverriegelungsschaltung (Slave-Latch). Gemäß dieser Erfindung werden die im Schieberegister vorhandenen Hauptverriegelungsschaltungen in Hauptgruppen durch Selektionssignale aufgeteilt und selektiert, wobei zum Zwecke des Ein-, Ver-oder Ausschiebens von Informationen den eine Unterkette bildenden Hauptverriegelungsschaltungen der ausgewählten Gruppe Hilfsverriegelungsschaltungen physikalisch zugeordnet werden, während gleichzeitig die nicht gewählten Gruppen von Hauptverriegelungsschaltungen eine Kette von virtuellen Schieberegisterstufen bilden.

Auch hier werden durch geschickte Aufteilung von Polarity-Hold-Master-Latchen zu Gruppen solche Schieberegister-Teilstufen geschaffen, welche die Funktion des Zwischenspeichers während des Schiebevorgangs ausüben, ohne daß zusätzliche Siliziumfläche für Slave-Latche benötigt wird.

In der europäischen Patentschrift 0 046 500 wird ein anderes Schieberegister für Prüf-und Testzwecke beschrieben, das ebenfalls auf dem Speicher-bzw. Logik-Chip angeordnet ist und des-sen Verriegelungsschaltungen aus solchen Elemen-ten gebildet werden, die bereits auf dem Chip für funktionelle Zwecke vorhanden sind. Gemäß dem eigentlichen Erfindungsgedanken werden diese funktionellen Verriegelungsschaltungen (Master-Latche) kaskadenweise zu Schiebeketten zusammengeschaltet, wobei in der ersten Schiebekette alle, das gesamte Schieberegister bildenden, Verriegelungsschaltungen enthalten sind und in der zweiten Schiebekette nur jede zweite Verriegelungsschaltung enthalten ist, so daß in der letzten Teilkaskade nur noch zwei Verriegelungsschaltungen vorhanden sind.

Das Problem, die Testdaten in die Tiefe der Chip-Struktur hineinzubringen und die Ergebnisdaten herauszuholen, wurde beim Testen von hochintegrierten Logik-und Speicher-Chips, die nach den LSSD-Entwurfsregeln aufgebaut wurden, auch -schon von der Systemseite her angegangen, wie beispielsweise die europäische Patentanmeldung 0 126 785 zeigt.

Bei der genannten europäischen Patentanmeldung werden zur Fehlerprüfung und -diagnose von elektronischen Datenverarbeitungsanlagen bestimmte, im normalen Betrieb die Logik-Subnetze, aus denen Prozessoren und Verarbeitungseinheiten bestehen, verbindende Speicherelemente (Master-Latche) zu einer adressierbaren Matrix zusammengeschaltet, die über den Systembus mit einem Wartungs-und Bedienungsprozessor oder einem externen Tester verbunden ist. Letztere übertragen über den Systembus Adressen zu der Matrix und Prüfdaten in die adressierten Speicherelemente, die diese dann den Logik-Subnetzen zuführen, die ihrerseits auf diese Prüfdaten reagieren und die so erhaltenen Teil-Resultatdaten an die Speicherelemente abgeben. Im nächsten Schritt rufen der Wartungs-und Bedienungsprozessor oder der externe Tester diese Ergebnisdaten zur Fehleranalyse und -diagnose aus den zu einer Matrix zusammengeschalteten Speicherelementen über den Systembus ab.

Es werden hier also keine Schieberegister mehr benutzt, sondern es werden die im Logikentwurf erforderlichen Speicherelemente (Master-Latche), welche die logischen Subnetze miteinander verbinden, zu einer Matrix zusammengeschaltet, die zum Zwecke der Testdateneingabe und Ergebnisdatenausgabe entsprechend adressiert wird.

Insbesondere das Kaskaden-Schiebekonzept (das in der bereits erwähnten europäischen Patentschrift 0 046 500 beschrieben ist und das sich besonders vorteilhaft beim Testen von integrierten Schaltkreisen anwenden läßt, ist für das Testen ultrahochintegrierter(ULSI-) Chips noch nicht geeignet. wie die nachstehenden Ausführungen zeigen sollen.

Dem Kaskaden-Schieberegister liegt eine Schiebetechnik zugrunde, bei der funktionellen Latche (LTi) 2 kaskadenförmig zu Schiebeketten verbunden sind, ohne dabei dedizierte Slave-Latche für die Zwischenspeicherfunktion verwenden zu müssen, wie Figur 4 zeigt. Die Verbindung der Latche ist so gewählt, daß die erste Schiebekette CH I alle funktionellen Latche LT1 bis LT8 in Form eines vollständigen, seriell verbundenen Schieberegisters einschließt. Die zweite Schiebekette CH II verbindet nur jedes zweite Latch LT2, LT4, LT6, LT8. In Figur 4 sind nur drei Schiebeketten CH I bis CH III für acht funktionelle (Master)-Latche dargestellt. Für mehr als acht funktionelle Latche müssen jeweils mehr als drei Schiebeketten gebildet werden.

Welche dieser Kaskaden-Schiebeketten während des Test-Schiebevorgangs zu den jeweiligen Zeitpunkten tatsächlich betätigt wird, bestimmen die Steuersignale TG0 und TG1, die in Figur 5 gezeigt sind. Mittels dieser Eingangssignale und der entsprechenden Decodierschaltung (DEC) 10a werden die zugehörigen Takttreiber CL-DR aktiviert. Damit wird die entsprechende Verbindungstopologie der gewünschten Kaskaden-Schiebekette von außerhalb des Chips selektiert. Mit Hilfe der Schiebetakte SH-CL1 und SH-CL2 kann nun die gewünschte Kette der funktionellen Latche betrieben werden (paralleles Schieben).

Während des jeweiligen Schiebevorganges in einer Kaskadenschiebekette dient jedes zweite funktionelle Latch als Zwischenspeicher (Slave-Latch) für das korrespondierende funktionelle Latch (Master-Latch). Funktionell werden jedoch alle Latche als Master-Latche verwendet. Damit die funktionellen Latche (LTi) an mehreren Kaskade-Schiebeketten teilnehmen können, werden die meisten von ihnen mit mehreren Schiebeeingängen versehen. Figur 5 zeigt ferner noch die Leitungen für die funktionellen Takte F-CLi und für die funktionellen Daten F-D sowie die abgeleiteten Schiebetaktsignale CL I 1, CL I 2, CL II 1, CL II 2 und CL III 1, CL III 2, für die drei dargestellten Schiebeketten CH I bis CH III.

Der Schiebevorgang läßt sich anhand der Figur 4 erläutern. Das funktionelle Latch LT8, das eine Sonderstellung einnimmt, kann durch die Testeinrichtung direkt beobachtet und sein Inhalt kann direkt übernommen werden, da sein Ausgang unmittelbar mit einem Chip-Anschluß (hier SH-O) verbunden ist. Nach der Übernahme der Information des funktionellen Latches LT8 durch die Testeinrichtung wird dieses Latch frei, so daß es danach als Zwischenspeicher (Slave-Latch) zum nachfolgenden Hinausschieben der Information des funktionellen Latches LT4 (Master-Latch) benutzt werden kann. Es ergibt sich hier ein Verschiebeweg längs der Leitungsstücke 11, 12, 13 und 26. Zwischen die Leitungsstücke 12 und 13 ist das funktionelle Latch LT4 und zwischen die Leitungsstücke 13 und 26 das Slave-Latch LT8 geschaltet. Wie Figur 5 zeigt, wird zu diesem Zweck die KaskadenSchiebekette CH III mittels der Signale TG0 und TG1 selektiert und mittels der Schiebetakte SH-CL1 und SH-CL2 betrieben.

Nach dem Hinausschieben des Inhaltes des funktionellen Latches LT4 und der Übernahme durch die Testeinrichtung wird auch dieses Latch frei und kann seinerseits als Zwischenspeicher (Slave-Latch) benutzt werden. Damit wären die beiden Latche LT8 und LT4 frei. Sie können nun als Slave-Latche innerhalb der Kaskaden-Schiebekette CH II verwendet werden. In Figur 4 entspricht dieser Verschiebeweg den Leitungsstücken 11, 14, 15, 16, 17, 26 mit den jeweils zwischengeschalteten Latchen LT2, LT4, LT6 und LT8. Die Selektion dieser Kette erfolgt ebenfalls wieder mittels der Signale TG0 und TG1 und die Verschiebung wird mittels der Schiebetakte SH-CL1 und SH-CL2 durchgeführt.

Nach dem Hinausschieben des Inhalts der funktionellen Latche LT6 und LT2 und der Übernahme ihres Inhalts durch die Testeinrichtung werden nun auch diese Latche frei und können somit, zusammen mit den bereits frei gewordenen Latchen LT8 und LT 4 als Slave-Latche innerhalb der Kaskaden-Schiebekette CH I verwendet werden. Auch diese Kette wird durch die oben genannten Signale selektiert und betrieben. Mit ihrer Hilfe kann auch die Information in den verbleibenden Latchen LT7, LT5, LT3 und LT1 hinausgeschoben und von der Testeinrichtung übernommen werden. Die Kaskaden-Schiebekette CH I verläuft somit längs der Leitungsstücke 11, 18, 19, 20, 21, 22, 23, 24, 25 und 26.

Die Verbindungsstruktur der Latche, der nach dem Kaskadenschiebekonzept entworfenen sequentiellen Logik, die in Figur 4 dargestellt ist, verläuft für den funktionellen Betrieb längs der Leitungsabschnitte 11, 18, 27, 28, 29, 30, 31, 32, 33, 34, 35, 36, 37, 38, 39, 40 und 26. Diese sind also die Leitungsabschnitte, welche die Latche LT1 bis LT8 mit der funktionellen Logik (F-LOG) 1 verbinden.

Der Nachteil dieses bekannten Kaskaden-Schiebekonzeptes liegt darin, daß mit länger werdenden Ketten die Anzahl der Eingänge zu den Latchen stark zunimmt, insbesondere beim Latch LT4, wie aus Figur 5 deutlich wird. Problematisch wird hier die hohe Zahl der internen DOT-Verbindungen (galvanische Verbindungen).

Dieser Nachteil der bekannten Kaskaden-Schiebetechnik verhindert ihre Verwendung beim Testen von ultrahochintegrierten Chips.

Die Erfindung hat sich daher die Aufgabe gestellt, eine Lösung anzugeben, die es ermöglicht, auch die Kaskaden-Schiebetechnik für das Testen von ultrahochintegrierten Chips nutzbar zu machen.

Gelöst wird diese Aufgabe der Erfingung durch die in den Ansprüchen 1, 5 und 6 angegebenen Merkmale.

Vorteilhafte Ausgestaltungen und Weiterbildungen des Gegenstandes der Erfindung sind den Unteransprüchen zu entnehmen.

Die durch die Erfindung vorgeschlagene gestaffelte Kaskaden-Schiebetechnik bietet eine Reihe von Vorteilen, einmal den Vorteil, daß sie das Testen von ultrahochintegrierten Chips ermöglicht, deren Logik-Schaltkreise nach den Prinzipien des pegelsensitiven Entwurfs aufgebaut sind. Dieses wiederum bedeutet Kostenersparnis durch einfachere Schaltkreise und eine weitere Erhöhung der Integrationsdichte, da für Schaltkreise auf den Chips, die lediglich der Testdurchführung dienen, nur wenig Siliziumfläche geopfert wird.

Ferner wird durch die vollständige Entkopplung der einzelnen Schiebeketten voneinander auch eine höhere Flexibilität unter Systemaspekten geboten, da die einzelnen Logikgruppen und Untergruppen mit verschiedener Geschwindigkeit betreibbar sind. Schließlich kann auch eine höhere Zugriffsgeschwindigkeit erzielt wer den, da so gut wie keine oder nur wenige Multiplexer erforderlich sind. Ganz allgemein sei noch festgestellt, daß die Staffelung von Kaskadenschiebekettengruppen den wesentlichen Vorteil aufweist, daß man damit eine sehr hohe Anzahl von funktionellen Latchen erfassen kann, wobei die einzelnen Kaskadenschiebekettengruppen zudem noch sehr kurz gehalten werden können. Im Vergleich zur Verwendung von langen Kaskadenschiebekettengruppen ermöglicht dieses eine größere Einsparung von Testschaltkreisen. Darüber hinaus kommt man auch mit einer niedrigeren Anzahl von Eingängen an den einzelnen Latchen aus.

Wegen der Vielfach-Decodierung in der Kettenzeitsteuerung ist besonders bei der Staffelung der Aufwand an Steuerschaltkreisen unerheblich. Ähnliche Überlegungen gelten bei Staffelanordnungen von Kaskadenschiebekettengruppen mit LSSD-Schiebeketten und Imaginär-Schiebeketten. Dadurch werden die Vorteile des Staffelungsprinzips von Testschaltungsanordnungen ermöglicht. Diese Überlegungen beziehen auch das Konzept mit überlagerten Latch-Matrizen ein, wobei hier gegenüber einem normalen Datenfluß-Multiplexor ein zusätzlicher Vorteil in Erscheinung tritt, nämlich der eines schnellen Zugriffs zu den Latchen der ersten Staffelebene, sowohl von außerhalb eines Höchstintegrations-Chips, als auch seitens der anderen Staffelebenen, wodurch eine Signalverzögerung durch die sonst benötigte vielstufige Multiplexor-Schaltungen vermieden wird.

Im folgenden wird die Erfindung anhand von durch Zeichnungen erläuterten Ausführungsbeispielen näher beschrieben. Es zeigen:

Fig. 1 bis 5 Prinzipdarstellungen zur Erläuterung des bekannten signalpegelabhängigen Entwurfsprinzips für hoch verdichtete Logikschaltkreise auf Chips und deren Testbarkeit mit Hilfe von Schiebestrukturen,

Fig. 6 eine Prinzipdarstellung einer gestaffelten Kaskaden-Schiebekettenanordnung,

Fig. 7 ein Zeitdiagramm zur Erläuterung des Hineinschiebens von Information in eine Kaskaden-Schiebekettengruppe (z.B. KSGO) der gestaffelten Kaskaden-Schiebekettenanordnung nach Fig. 6,

Fig. 8 ein Zeitdiagramm zur Erläuterung des Hinausschiebens von Information aus einer Kaskaden-Schiebekettengruppe (z.B. KSGO),

Fig. 9A, B eine detailliertere Darstellung der gestaffelten Kaskaden-Schiebekettenanordnung nach Fig. 6.

Fig. 10A, B ein Zeitdiagramm zum vollständigen Hineinschieben von Information in eine gestaffelte Kaskaden-Schiebekettenanordnung nach Fig. 6, bzw. Fig. 9A, B,

Fig. 11A, B ein Zeitdiagramm zur Erläuterung des vollständigen Hinausschiebens von Information aus einer gestaffelten Kaskaden-Schiebekettenanordnung nach Fig. 9A, B,

Fig. 12 eine Prinzipdarstellung einer gestaffelten Kaskaden-Schiebekettenanordnung nach Fig 6, bei der die Verbindungs-Schiebekette (CH O) als Imaginär-Schieberegister ausgebildet ist,

Fig. 13 eine Prinzipdarstellung einer gestaffelten Kaskaden-Schiebekettenanordnung nach Fig. 6, bei der die Verbindungs-Schiebekette (CH O) als Kaskaden-Schieberegister ausgebildet ist,

Fig. 14A, B eine Prinzipdarstellung einer gestaffelten Kaskaden-Schiebekettenanordnung, bestehend aus drei Schiebedimensionen (LVLO bis LVL2),

Fig. 14C eine vereinfachte Prinzipdarstellung der Anordnung nach den Fig. 14A, B,

Fig. 15A, B ein Zeitdiagramm zur Erläuterung des vollständigen Hineinschiebens von Information in eine Anordnung nach den Fig. 14A, B,

Fig. 15C eine Prinzipdarstellung zur Erläuterung der Ablauffolge der Teil-Zeitdiagramme, die in den Fig. 15A, B dargestellt sind,

Fig. 16A, B ein Zeitdiagramm zur Erläuterung des vollständigen Hinausschiebens von Information aus einer Anordnung nach den Fig, 14A, B,

Fig 16C eine Prinzipdarstellung zur Erläuterung der Ablauffolge der Teil-Zeitdiagramme, die in den Fig. 16A, B dargestellt sind.

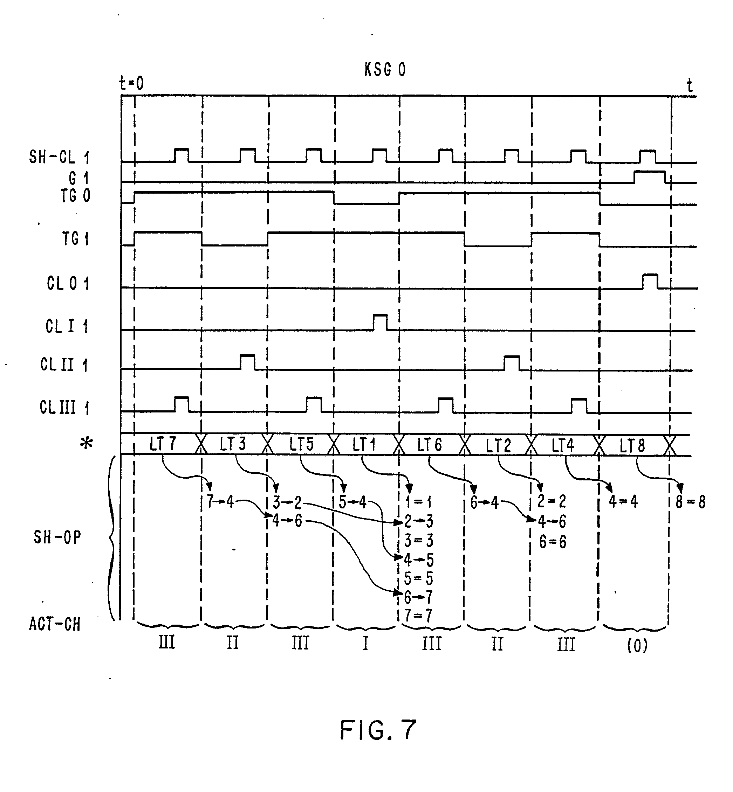

Ausgehend von der Kaskaden-Schieberegisteranordnung nach Figur 4 oder 5, kann eine große Anzahl von einzelnen Kaskade-Schiebekettengruppen gestaffelt angeordnet werden, wobei die funktionellen Latche LT8 der einzelnen Kaskaden-Schiebekettengruppen davon unabhängig zu einer konventionellen LSSD-Schiebekette, wie in Figur 7 dargestellt oder zu einer Imaginär-Schiebekette (vgl. Europäische Patentschrift 0 046 499) oder zu anderen Schiebeoder Zugriffsschaltungen verbunden werden. Diese neue Kette wird als Kaskaden-Schiebekette CH 0 bezeichnet. Mit Hilfe der Kaskaden-Schiebekette CH 0 können die Latche (M)LT8 direkt, d.h. ohne Benutzung der einzelnen Kaskaden-Schiebekettengruppen gelesen oder eingestellt werden. Hierdurch wird ein sehr wichtiges Problem, nämlich das Symmetrieproblem gelöst, welches beim Hineinschieben der individuellen Kaskaden-Schiebekettengruppen auftritt. Dadurch können die einzelnen Kaskaden-Schiebekettengruppen entsprechend dem in Figur 7 dargestellten Zeitdiagramm auch für den Einschiebevorgang (Einstellen der Schieberegisterstufen auf bestimmte Bitkombinationen) voll symmetrisch betrieben werden.

Um auch für die Latche LT1 einen direkten Zugang von außerhalb des Chips zu ermöglichen, sind ihre Eingänge unmittelbar mit den entsprechenden Ausgängen der Latche (M)LT8 verbunden. Die Kaskaden-Schiebekette CH 0 kann separat mittels derjenigen Schiebetakte betrieben werden, die von den Schiebetakten SH-CL1 und SH-CL2 mit Hilfe eines zusätzlichen Codewortes der Teststeuersignale TG0 und TG1 abgeleitet werden. Beispiele dieser Codewörter (01), (10) und (11) sind in Figur 5 im Decoder 10 dargestellt.

Mit der gestaffelten Struktur der Kaskadenschiebekettengruppen kann Information für alle funktionellen Latche LTi eines ultrahochintegrierten Chips durch eine zusammengesetzte Operation von parallelen Schiebevorgängen aller einzelnen Kaskadenschiebegruppen und von jeweils nachfolgenden, davon unabhängigen Schiebevorgängen der Kaskadenschiebekette CH 0 hinein-oder hinausgeschoben werden, wie Figur 7 im einzelnen zeigt. Diese Anordnung erlaubt somit die Nutzung der schnellen symmetrischen Schiebevorgänge der einzelnen Kaskadenschiebegruppen auf einem ULSI-Chip.

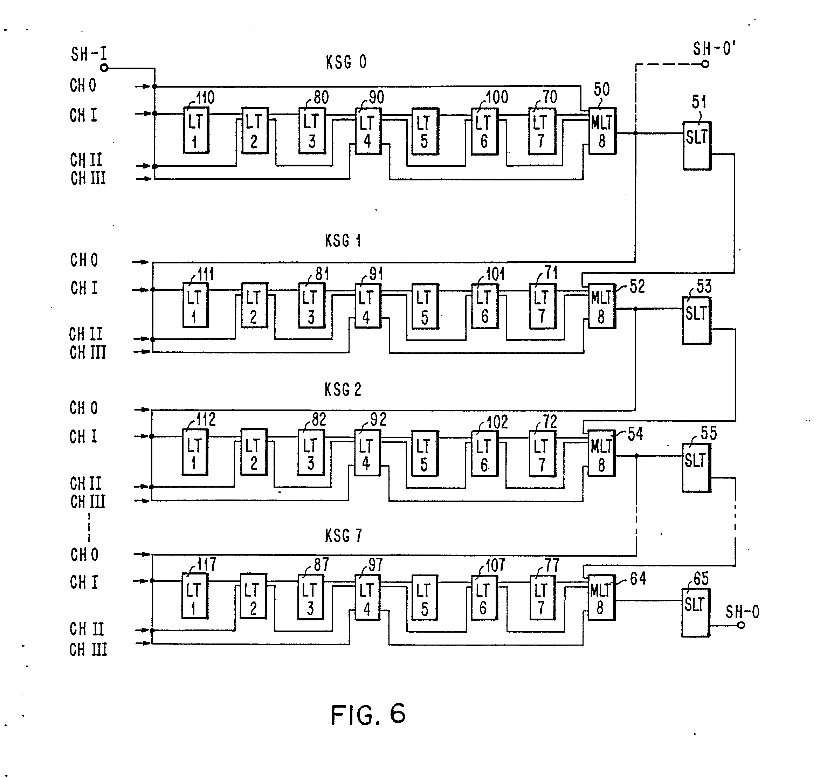

Ausgehend von einer gestaffelten Schiebekettenanordnung nach Figur 6, zeigt Figur 7 ein Zeitdiagramm für das symmetrische Hineinscheiben von Information, wobei die 8. Zeile von oben, die mit einem Stern (*) gekennzeichnet ist, zeigt, für welches Latch die Eingangsinformation am Schiebedateneingang SH-I bestimmt ist, und für welche Taktperiode dieses gilt. Es ist aus Figur 7 ferner zu sehen, daß für das Hineinschieben nur ein Schiebetakt, und zwar der Schiebetakt SH-CL1 sowie die Steuersignale TG0 und TG1 erforderlich sind. Als abgeleitete Takte werden benötigt CL01, CL I 1, CL II 1 und CL III 1. Die jeweils aktive Kette ACT-CH zeigt die letzte Zeile in Figur 7. Die verschiedenen Einzel-Schiebeoperationen sind in den Zeilen SH-OP dargestellt.

Mit dem ersten Impuls des Schiebetaktes SH-CL1 und auf binär 1 gesetzten Signalen TG0 und TG1 wird das Taktsignal CL III 1 erzeugt, das die Schiebekette CH III aktiviert. Damit wird die am Schiebedateneingang SH-I anliegende und für das Latch LT7 bestimmte Information in das Latch LT4 hineingeschoben.

Mit dem zweiten Impuls des Schiebetaktes SH-CL1, bei TG0 = 1 und TG1 = 0, wird der abgeleitete Taktimpuls CL II 1 erzeugt, wodurch die Kette CH II aktiviert wird. Dadurch wird die für das Latch LT7 bestimmte und momentan im Latch LT4 befindliche Information in das Latch LT6 verschoben. Gleichzeitig wird die am Schiebedateneingang SH-I anliegende und für das Latch LT3 bestimmte Information in das Latch LT2 geschoben.

Mit dem dritten Impuls des Schiebetaktes, bei TG0 = 1 und TG1 = 1 wird wieder der Taktimpuls CL III 1 erzeugt, der die Schiebekette CH III aktiviert. Dadurch wird die für das Latch LT5 bestimmte Information in das Latch LT4 geschoben. Dieses ist ohne Informationsverlust möglich, da im Takt zuvor ja der Inhalt des Latches LT4 in das Latch LT6 verschoben wurde.

Auf diese Weise gelangt die für die einzelnen Latche LTi bestimmte Information über den Schiebedateneingang SH-I in die entsprechenden Latche. Eine Besonderheit nimmt, wie bereits erwähnt wurde, der Latch LT8 ein, da er zur Verbindungskette der Kaskadenschiebekettengruppen gehört. Das Latch LT8 wird zuletzt mit Information beschickt. Hierzu dient der letzte Impuls des Schiebetaktes, der bei TG0 = 0 und TG1 = 0 den abgeleiteten Taktimpuls CL 0 1 erzeugt. Dadurch wird die Schiebekette CH0 aktiviert und die für das Latch LT8 bestimmte Information wird direkt vom Schiebedateneingang SH-I übernommen. Damit sind dann alle Latche LT1 bis (M)LT8 der obersten Kaskadenschiebekettengruppe KSG0 mit der für sie bestimmten Information geladen. Die Master-Slave-Latch-Kombination bestehend aus Master-Latch MLT8 und Slave-Latch SLT am Ende der betrachteten Kaskaden-Schiebekettengruppe KSG0 bleibt zunächst noch außer Betracht.

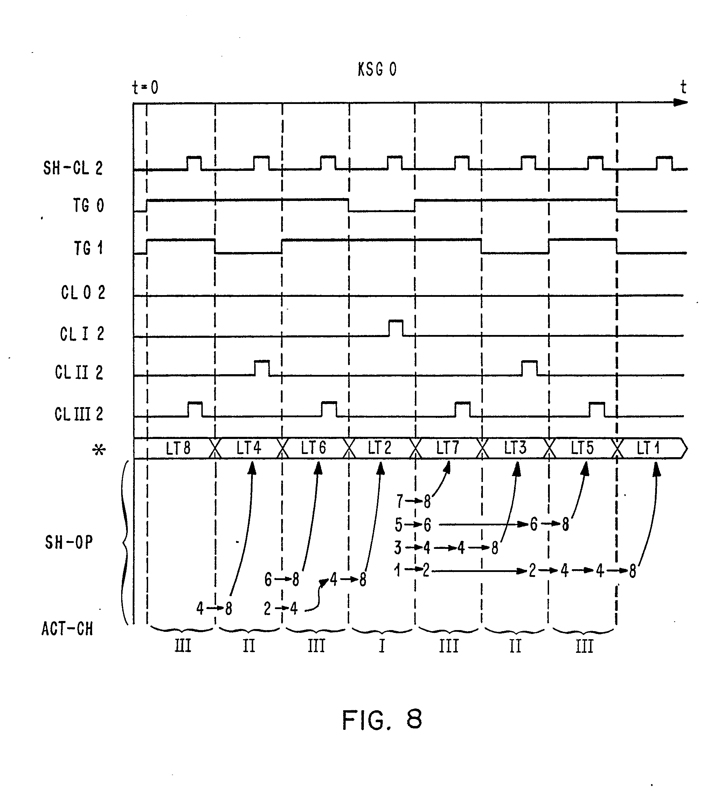

Zur Erläuterung des Hinausschiebevorganges, beispielsweise ebenfalls an Hand der Kaskaden-Schiebekettengruppe KSG0, wird angenommen, daß sie mit Information geladen ist. Gesteuert wird der Hinausschiebevorgang mit dem Schiebetakt SH-CL2 und den aus diesem abgeleiteten Schiebetakten CL 0 2, CL I 2, CL II 2 und CL III 2, wie Figur 8 zeigt. Für die Erzeugung der abgeleiteten Taktsignale haben die Steuersignale TG0 und TG1 den in Figur 8 dargestellten Verlauf. Zu Beginn des Hinausschiebens steht die Information im Latch (M)LT8 am Schiebeausgang SH-O' zur Verfügung und kann dann dort abgenommen werden. Mit dem abgeleiteten Schiebetakt CL III 2 wird die Kette CH III aktiviert, so daß der Inhalt von Latch LT4 in das Latch LT8 gelangt und somit am Schiebeausgang SH-O' abgenommen werden kann.

In Figur 8 ist die Information, die am Schiebeausgang SH-O' abgenommen werden kann, in der Zeile dargestellt, die mit einem Stern gekennzeichnet ist.

In der nächsten Taktperiode wird mit Hilfe des abgeleiteten Taktes CL II 2 die Kette CH II aktiviert, so daß der Inhalt des Latches LT6 über das Latch LT8 am Schiebeausgang abgenommen werden kann. Zur gleichen Zeit wandert die im Latch LT2 befindliche Information in das Latch LT4.

Danach wird der abgeleitete Takt CL III 2 erzeugt, der wieder die Schiebekette CH III aktiviert. Da über das Latch LT8 der Inhalt des Latches MLT6 schon abgegriffen werden konnte, ist das Latch LT8 nun frei geworden, so daß längs des Weges der Schiebekette CH III der Inhalt des Latches LT4 zum Latch LT8 und von dessen Ausgang zum Schiebeausgang SH-0 gelangt. Durch den darauf folgenden abgeleiteten Schiebetaktimpuls CL I 2 wird nun die Schiebekette CH I aktiviert, so daß die Information im Latch LT7 über das Latch LT8 zum Schiebedatenausgang zwecks Abnahme gelangt. Gleichzeitig wird der Inhalt von Latch LT5 zum Latch LT6, der Inhalt vom Latch LT3 zum Latch LT4 und schließlich der Inhalt des Latches LT1 zum Latch LT2 übertragen.

Auf die in Figur 8 dargestellte Weise gelangt schließlich als letzte Information der Inhalt des Latches LT4 zum Latch LT8 und damit zum Schiebedatenausgang SH-O', von wo er dann zu anderen Abnehmern weiter übertragen werden kann.

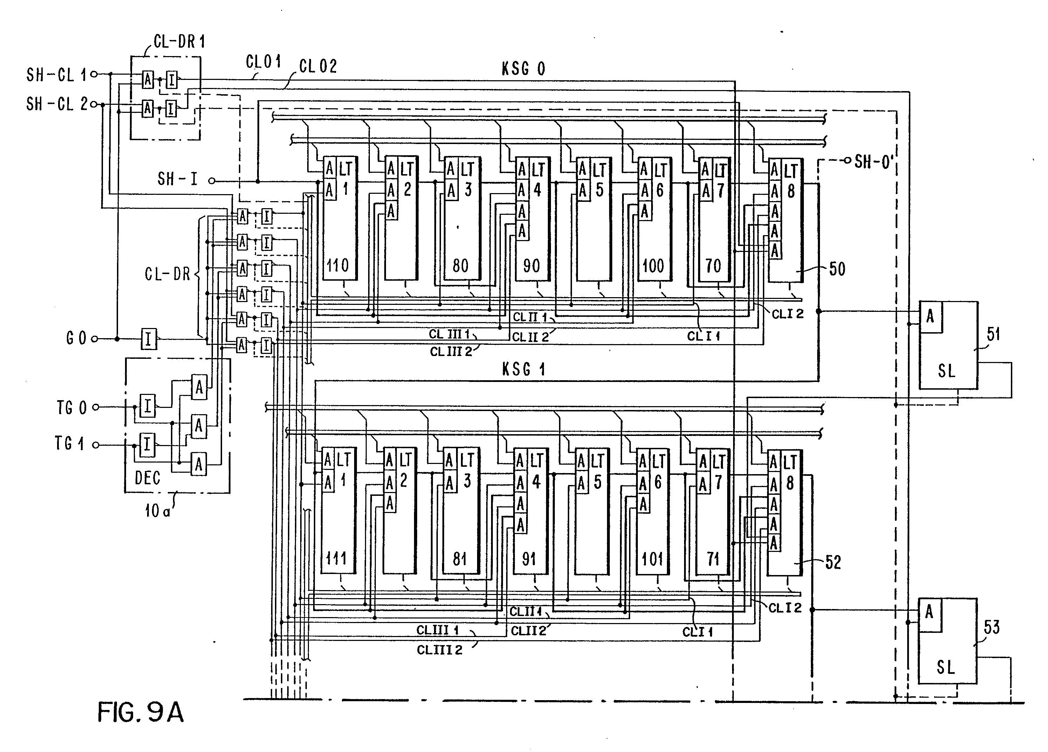

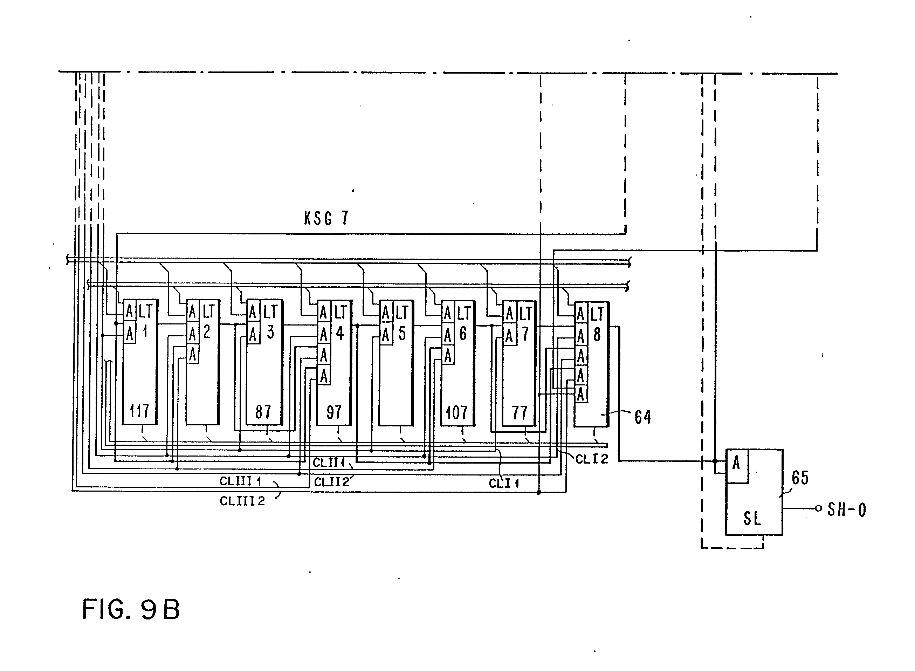

Figur 6 und in detaillierterer Darstellung Figuren 9A, B zeigen eine Anordnung, die insgesamt aus 8 Kaskaden-Schiebekettengruppen KSG0 bis KSG7 besteht, die über die Schiebekette CH 0 miteinander verbunden sind. Diese Schiebekette CH 0 verbindet die jeweils letzten Master-Latche (MLT8) 50 bis 64, wobei die Figuren 6 und 9A, B diese Verbindung in Form einer normalen Schieberegisteranordnung zeigt, bestehend aus einem Master-Latch 50 mit nachgeschaltetem Slave-Latch 51, das wiederum mit dem Master-Latch 52 der nachfolgenden Stufe verbunden ist. Für die Steuerung einer Anordnung nach Figur 6 bzw. Figuren 9A, B wird noch ein weiteres Steuersignal GO eingeführt, das in Verbindung mit dem Taktsignaltreiber CL-DR1 die Erzeugung der abgeleiteten Schiebetaktsignale CL 0 1 und CL 0 2, die zum Betreiben der Schiebekette CH 0 benötigt werden, steuert.

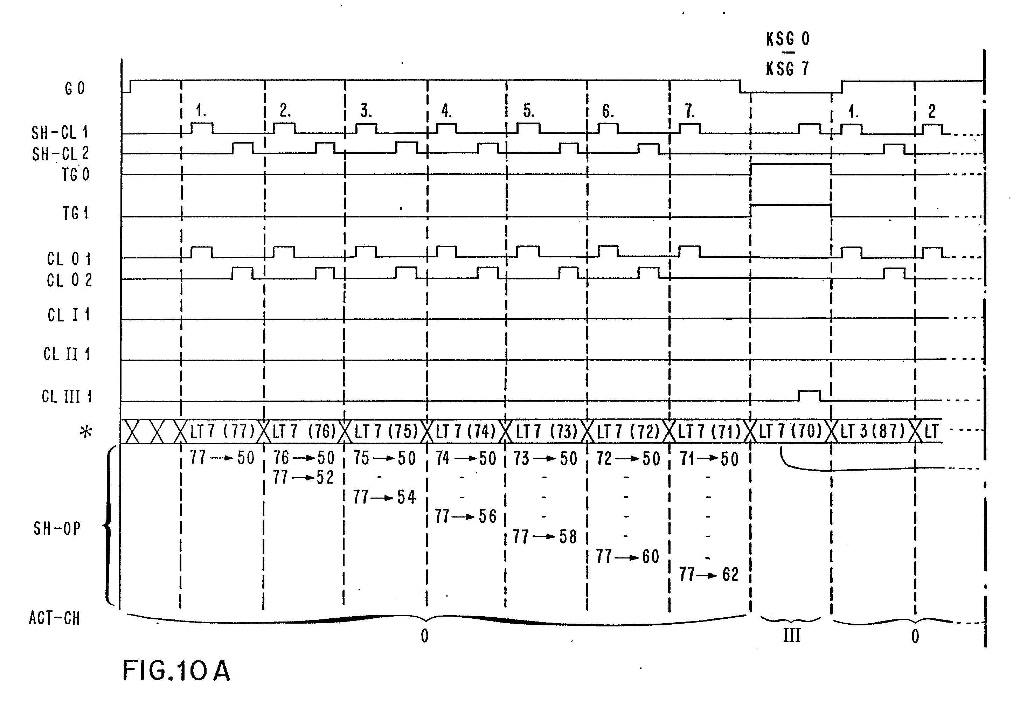

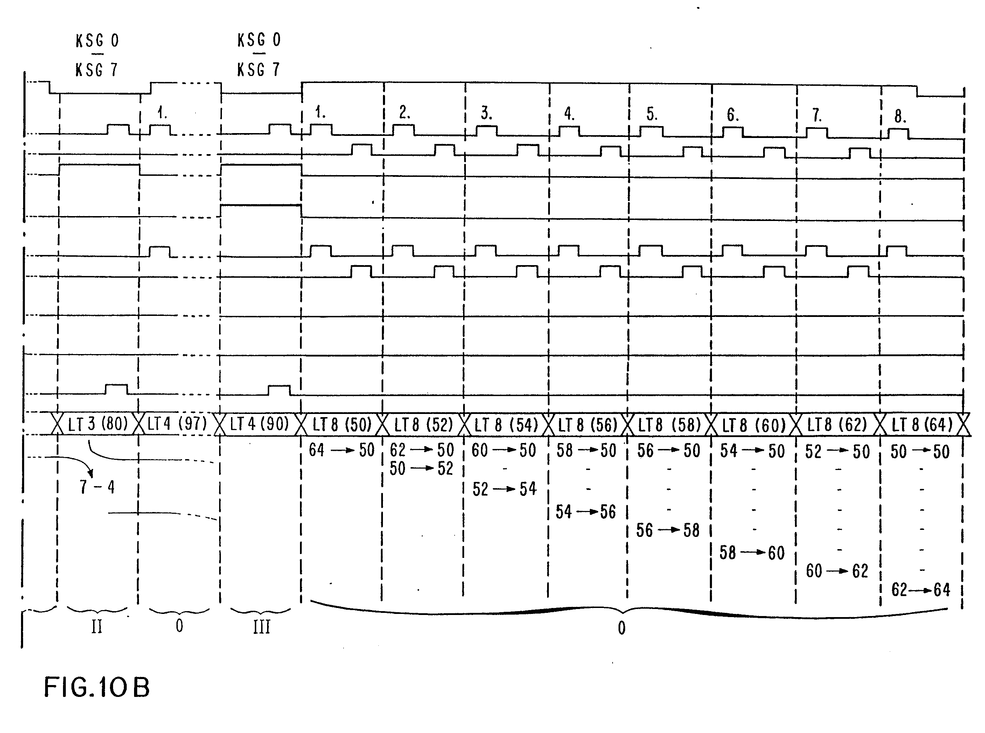

Für das Hineinschieben von Information über den Schiebedateneingang SH-I wird über die Schiebekette CH 0, die, wie in Figure 6 dargestellt, beispielsweise ein normales Schieberegister sein kann, zunächst, wie die Figuren 10A, B zeigen, mit Hilfe von sechs abgeleiteten Schiebetaktpaaren CL 0 1, CL 0 2 und einem siebtem Taktimpuls des Taktes CL 0 1 die Information in die Schiebekette CH 0 eingegeben, die nach Figur 6 für die Latche (LT7) 70 bis 77 vorgesehen ist. Danach wird in allen Schiebekettengruppen KSG0 bis KSG7 die Kette CH III mit Hilfe des Taktimpulses CL III 1 aktiviert, so daß der gleiche Vorgang abläuft, wie er in Figur 7 im ersten Abschnitt von links bezüglich der aktiven (ACT) Kette CH III dargestellt ist. Es folgt dann wieder ein Nachladevorgang hinsichtlich der Kette CH 0, die nun die Information aufnimmt, die letztlich für die Latche (LT3) 80 bis 87 bestimmt ist.

Danach wird folgerichtig die Schiebekette CH II aktiviert, so daß in allen acht Schiebekettengruppen Vorgänge ablaufen, wie sie in Figur 7 im zweiten Abschnitt von links dargestellt sind.

Dieses Wechselspiel zwischen der Aktivierung der Schiebekette CH 0 und den übrigen Schiebeketten CH i wird fortgesetzt, bis alle Latche, mit Ausnahme der Latche (LT8) 50 bis 64 geladen sind. Diese Latche, die bekanntlich die Schiebekette CH 0 bilden, werden mit ihrer letzten Aktivierung geladen. Die Figuren 10A, B zeigen die hierzu erforderlichen Schiebeoperationen SH-OP im unteren Bereich.

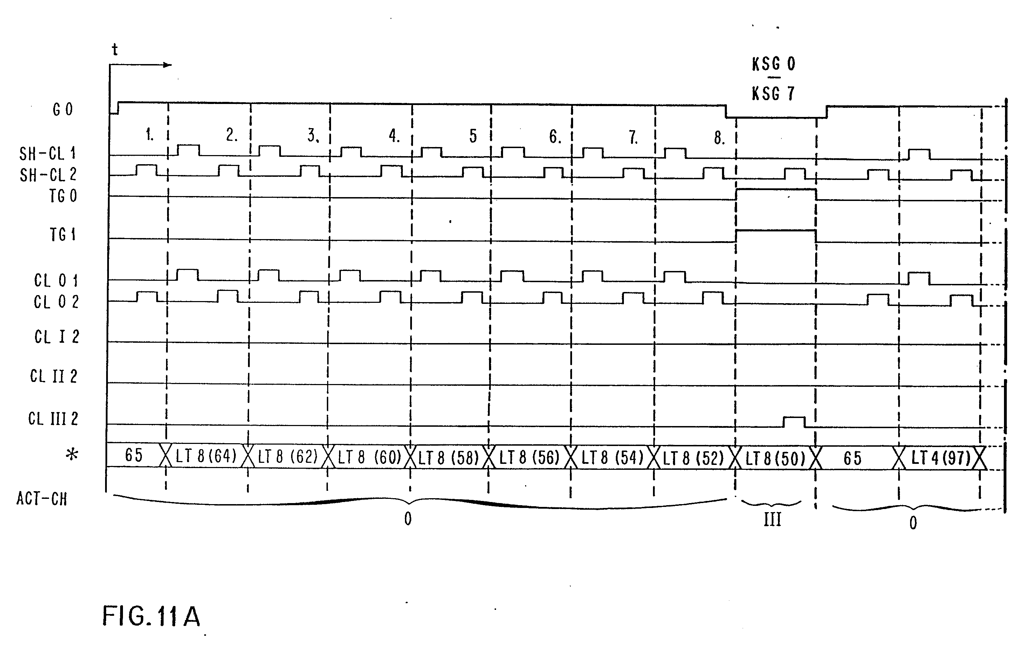

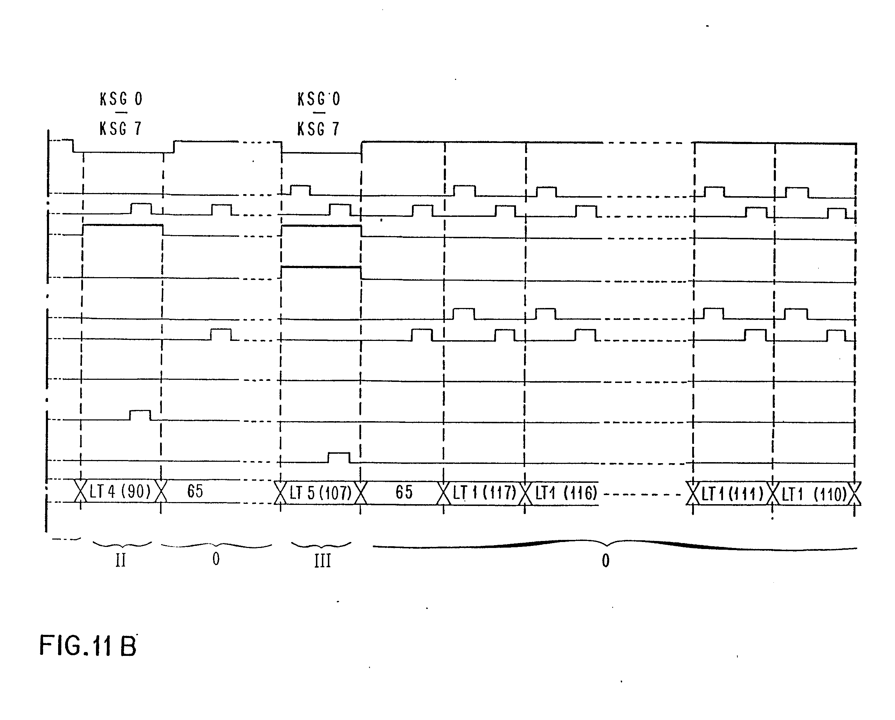

Beim Hinausschieben einer mit Information vollständig geladenen Anordnung nach Figur 6 bzw. Figuren 9A, B spielen sich ähnlich verschachtelte Vorgänge zwischen der Aktivierung der Schiebekette CH 0 und den übrigen Ketten CH i ab, wie beim Hineinschieben von Information. Es wird beim Hinausschieben allerdings zuerst die Schiebekette CH 0 mit Hilfe der abgeleiteten Schiebeimpulspaare CL 0 1 und CL 0 2 freigemacht. Auf dem Schiebedatenausgang SH-O, in Figur 11 mit '-Zeichen bezeichnet, wird zunächst mit Hilfe des abgeleiteten Schiebetaktes CL 0 2 das Slave-Latch (SLT) 65, dessen Inhalt unberücksichtigt bleibt, hinausgeschoben. Es folgt dann eine normale Schieberegisteroperation der LSSD-Schiebekette CH 0 durch welche die Inhalte aller Latche dieser Kette (MLT8) 50 bis 64 hinausgeschoben werden. Es folgt dann die Aktivierung der Schiebekette CH III parallel für alle Schiebekettengruppen KSG0 bis KSG7, wodurch Vorgänge ablaufen, wie sie in Figur 8 im linken Abschnitt dargestellt sind.

Dieses wiederholt sich, wie auch schon beim Hineinschieben, noch siebenmal, so daß bei der letzten Aktivierung der Schiebekette CH 0 die Inhalte der ersten Latche (LT1) 110 bis 117, sich nun in den letzten Stufen (MLT8) 50 bis 64 befinden, die bekanntlich Glieder der Schiebekette CH 0 sind, von wo sie durch eine normale Schieberegisteroperation auf den Schiebedatenausgang SH-O gelangen.

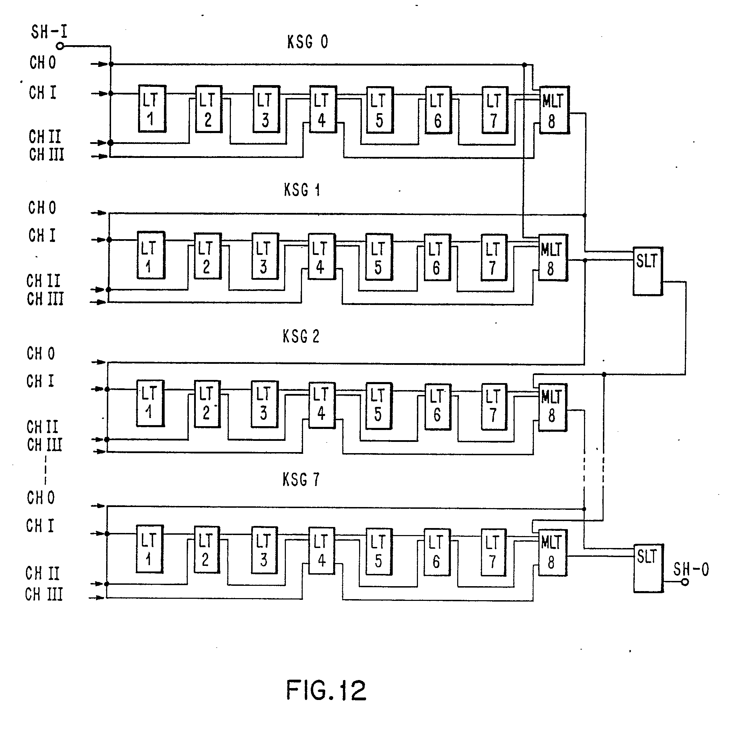

Um weiterhin der Aufgabe der vorliegenden Erfindung gerecht zu werden, nämlich für von Slave-Latchen benötigte Siliziumfläche einzusparen, die nur als Zwischenspeicher bei Testoperationen erforderlich sind, wird in Figur 12 eine Anordnung dargestellt, in welcher die Schiebekette CH 0, wie sie in den Figuren 6 bzw. 9A, B gezeigt ist, durch eine bekannte Imaginär-Schieberegisterkette ersetzt ist.

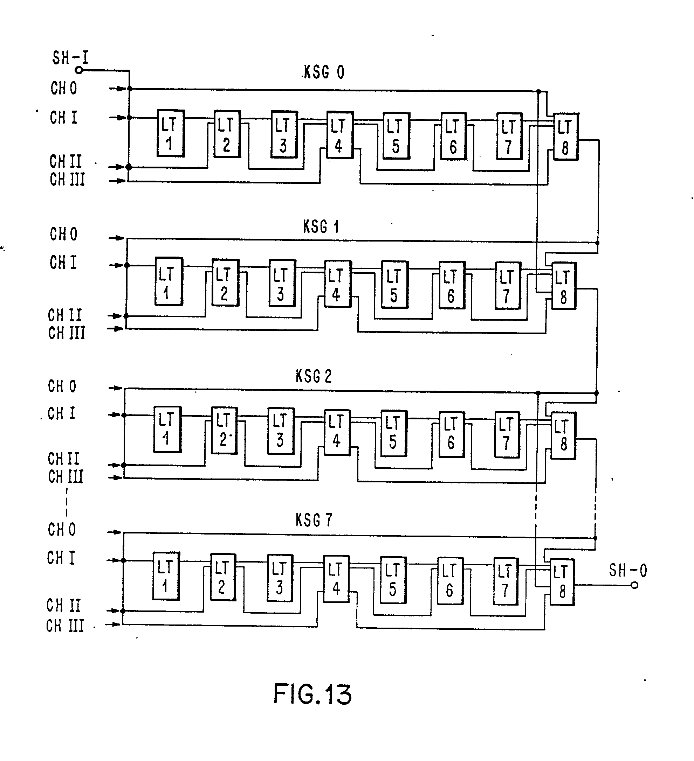

Eine weitere Verbesserung ist in Figur 13 dargestellt, wo die Schiebekette CH 0 als Kaskaden-Schiebekette aufgebaut ist. Bei dieser letzten Lösung sind keine SlaveLatche mehr als Zwischenspeicher für Testzwecke erforderlich.

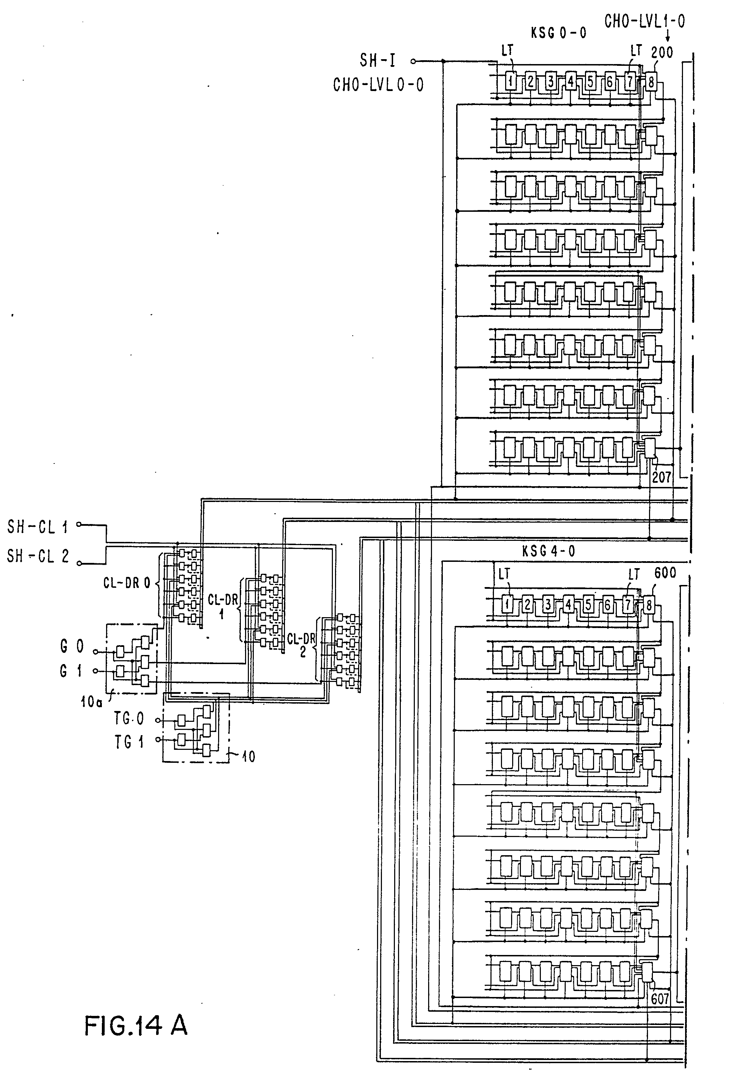

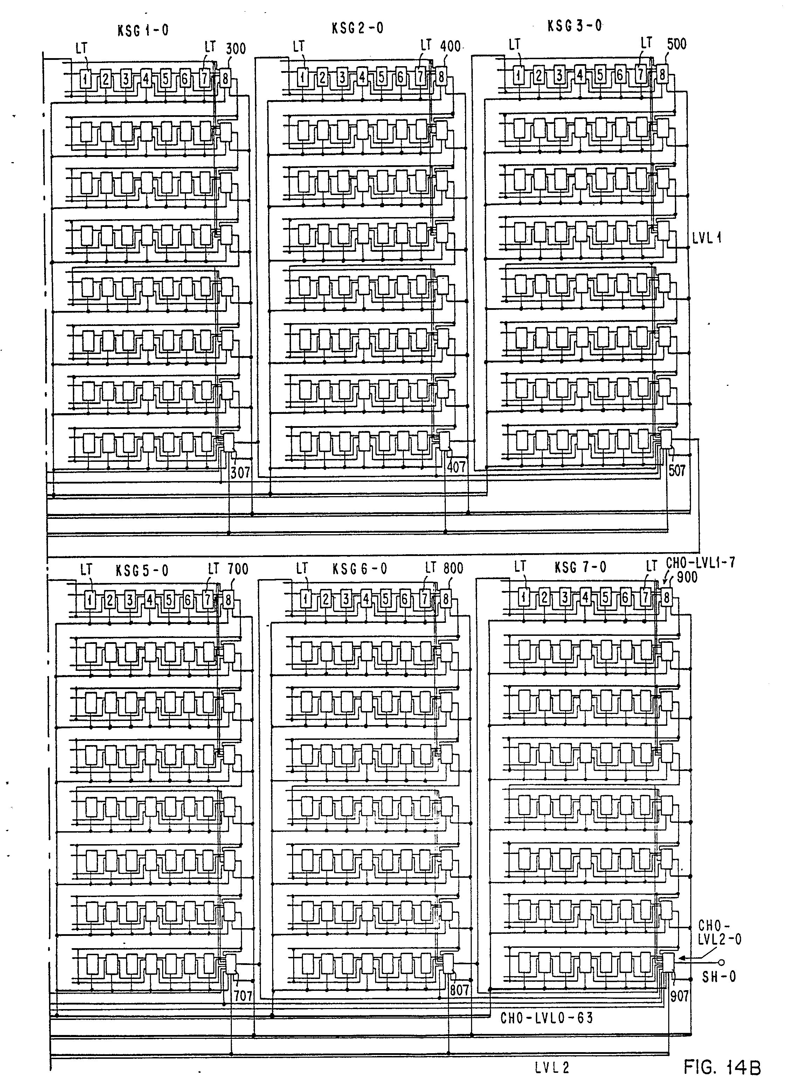

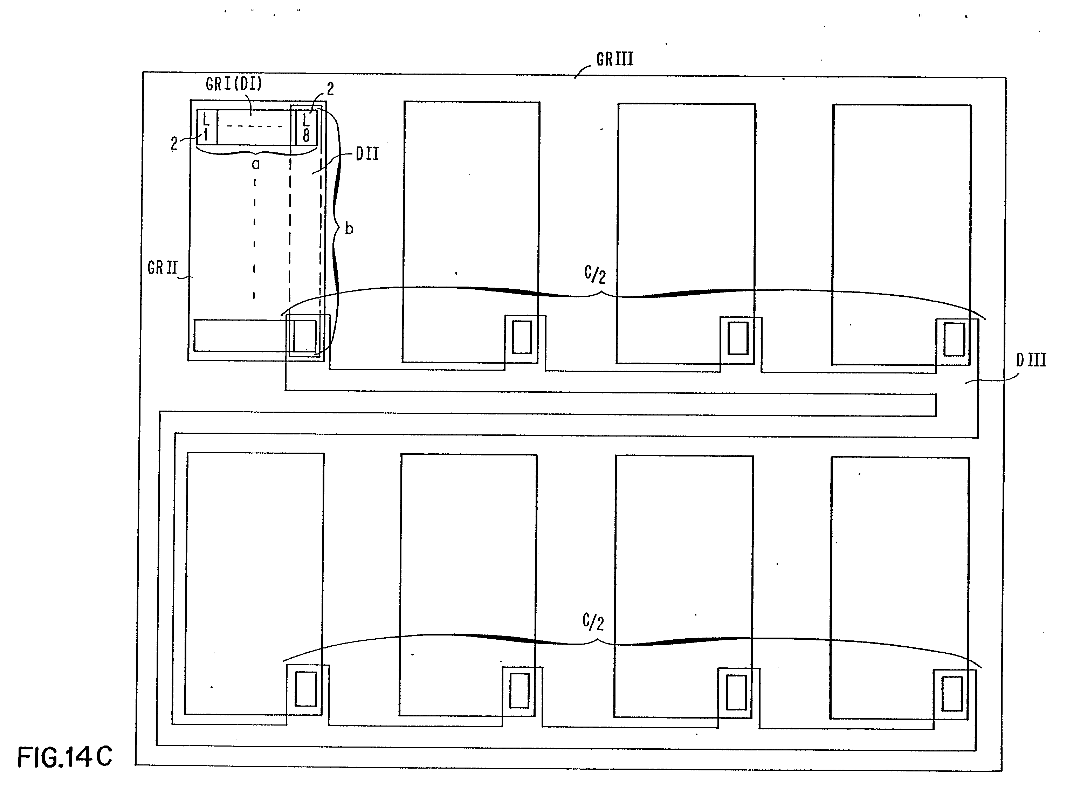

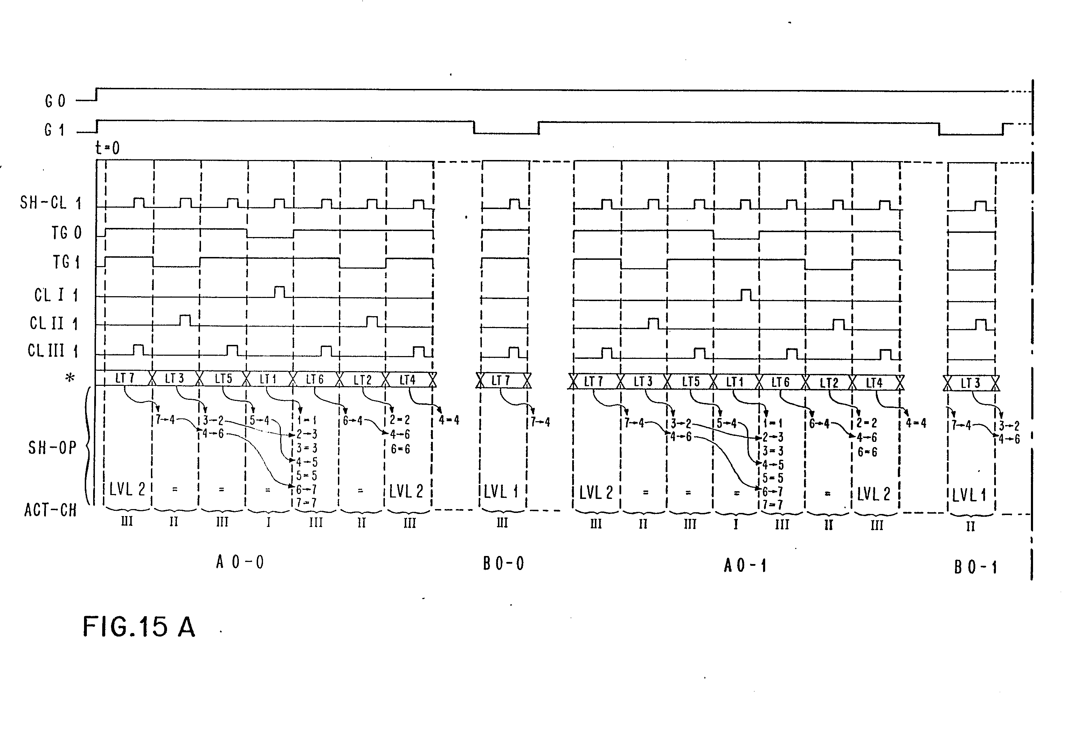

Bei der hohen Packungsdichte der Schaltkreise auf den Halbleiter-Chips müssen andere Gruppierungen verwendet werden, um die hohe Anzahl der Latche zu schiebefähigen Strukturen zusammenschalten zu können. Ein Beispiel für eine kompaktere Anordnung zeigen die Figuren 14A, B. Es sind hier insgesamt 8 Anordnungen nach Figur 13 zusammengefaßt, die zu ihrer kompletten Steuerung lediglich ein weiteres Steuersignal, nämlich G1, benötigen (vgl. auch Figuren 9A, B). Wie insbesondere ein Vergleich der Figuren 9A, B und 14A, B miteinander zeigt, ist der zusätzliche Steuerungsaufwand sehr gering, nämlich nur eine Takttreibergruppe und einen Decodierer mehr, welch letzterer für die Staffelungsebenen( = Schiebedimension s-)selektion, auf die noch näher eingegangen werden wird, benötigt wird.

In der untersten (ersten) Staffelungsebene LVL0 ( = Schiebedimension DI in Figur 14C) befinden sich alle Schiebeketten CH 0, die aus Gründen der Systematik in CH 0-LVL0 umbenannt werden. In dieser Ebene befinden sich ferner die Schiebeketten CH I, CH II und CH III aller Schiebekettengruppen KSG0 bis KSG7.

Die Zusammenfassung der jeweils letzten Latche der Ketten (CH 0-LVL0) 200 bis 207, 300 bis 307, ... 900 bis 907 führt wieder zu Schiebekettengruppen CH 0-LVL1-0 bis CH 0-LVL1-7, bestehend aus den Latchen 200 bis 207 .?.. 900 bis 907, deren jeweils letzte Latche 207, 307 ... , 907 wieder zu einer Schiebekettengruppe CH 0-LVL2 zusammengefaßt werden können, die dann die dritte Staffelungsebene LVL2 bilden (LVL2 entspricht Schiebedimension DIII).

Die Auswahl bzw. Ansteuerung der drei Staffelungsebenen für das Laden und Entladen aller Schieberegisterstufen erfolgt über die bereits eingangs erwähnte Decodierung der Steuersignale G0 und G1. Hierfür ist der Decodierer 10a vorgesehen.

Die einzelnen Kaskaden-Schiebekettengruppen in jeder Staffelebene (bzw. Schiebedimension) sind voneinander unabhängige Gebilde, die mittels der Taktsignale betrieben werden, die von den beiden Schiebetakten SH-CL1 und SH-CL2 und mit Hilfe der beiden Steuersignale TG0 und TG1 erzeugt werden. Diese Taktsignale sind die abgeleiteten Taktsignale, die zuvor schon erläutert wurden (z.B. CL 0 1, CL I 1, CL I 2, ..., CL III 2).

Es kann nicht deutlich genug hervorgehoben werden, daß zur topologischen Umgruppierung der Schiebeketten während des Schiebebetriebes nur Zeittaktsignale für die Ansteuerung der Latche benutzt werden und nicht die unmittelbar von außen zugeführten Selektionssignale oder von ihnen durch reine Decodierung abgeleitete Steuersignale.

Dies führt dazu, daß bei mehrdimensionalen Schiebestrukturen in jeder Staffelungsebene (Schiebedimension) jeweils eigene Taktsignale benutzt werden, die von den zwei reinen Schiebetaktsignalen SH-CL1 und SH-CL2 mit Hilfe der Steuersignale aus der für mehrere Staffelungsebenen (Schiebedimensionen) gemeinsam benutzten Decodierschaltung abgeleitet werden, wobei die dem zu testenden Chip zugeführten Testselektionssignale TG0 und TG1 eine entscheidende Rolle spielen. Zur jeweiligen Ansteuerung der einzelnen Staffelungsebenen (Schiebedimensionen) werden dann zusätzliche Selektionssignale G0 und G1 benutzt, die nach ihrer Decodierung die jeweiligen Takttreiberschaltungen CL-DR für die einzelnen Staffelungsebenen (Schiebedimensionen) direkt aktivieren. Dadurch kann der Schaltungsaufwand für die Ansteuerung der Schiebeketten geringer gehalten werden.

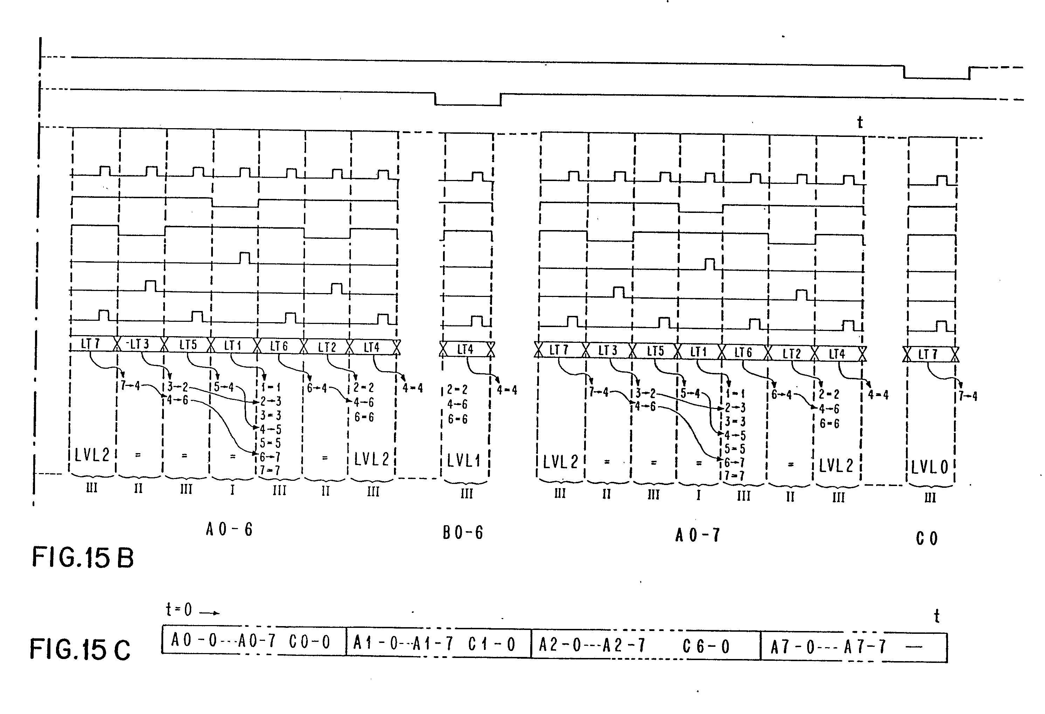

Figur 15 zeigt ein Zeitdiagramm für das symmetrische Hineinschieben von Information in $2^3$ = 512 Latche einer Staffelanordnung von Kaskadenschiebegruppen, wie sie in den Figuren 14A, B bzw. 14C dargestellt ist.

Das Zeitdiagramm in den Figuren 15A, B setzt sich aus mehreren Teilzeitdiagrammen A0-0, B0-0, A0-1, B0-1, ... B0-6, A0-7 und C0 zusammen, das zum vollständigen Laden einer Großgruppe GRIII in Figur 14C siebenmal wiederholt, das heißt insgesamt achtmal ausgeführt werden muß, wie Figur 15C schematisch zeigt.

Mit Ausführung des Teilzeitdiagramms A0-0 werden zunächst alle Latche der Verbindungskaskadenkettengruppe der dritten Staffelebene LVL2, (bzw. Schiebedimension DIII), mit Ausnahme des letzten Latches, gesetzt. Es werden also gesetzt (vgl. Figuren 14A, B) die Latche 207, 307, 407, 507, 607, 707 und 807. Eine weitere Schiebeoperation für das Laden des letzten Latches 907 ist nicht erforderlich, da die Information für die Latche 200 bis 206 der ersten Kette CH 0-LVL1-i am Schiebedateneingang SH-I anliegt, Verhältnisse also, wie sie auch im Zusammenhang mit dem Laden der in den Figuren 6 bzw. 9A, B dargestellten Anordnung vorlagen.

Das Teilzeitdiagramm B0-0, das sich unmittelbar anschließt, wird benötigt, um gleichzeitig die Information in diesen Latchen in die Verbindungskaskadenkettengruppen der zweiten Staffelebene LVL1 (bzw. Schiebedimension DII) zu übertragen, wobei das Setzen der ersten Kette CHO-LVL1-i über den Schiebedateneingang SH-I erfolgt. Es gelangt also der Inhalt von 207 in den Latch LT4 der Schiebekettengruppe KSG1-0, der Inhalt von 307 in den Latch LT4 von KSG2-0, der Inhalt von 407 in LT4 von KSG3-0 ... und schließlich der Inhalt von 807 in LT4 von KSG7-0.

Nun wird das Teilzeitdiagramm A0-0 als Teilzeitdiagramm A0-1 wiederholt.

Daran schließt sich wieder ein Zeitteildiagramm B0-1 an, durch dessen Ausführung die nachfolgenden Latchinhalte der Schiebekette CH 0-LVL2 in die Verbindungskaskadenkettengruppe der ersten Staffelebene LVL0 (bzw. Schiebedimension DI) übernommen werden.

Nach insgesamt achtmaligem Ausführen dieser Prozedur sind dann alle Latche der Verbindungskaskadenkettengruppen CHO-LVL1-i mit den neuen Inhalten gesetzt.

Am Ende der achtmaligen Ausführung wird Teilzeitdiagramm C0 ausgeführt. Dadurch werden gleichzeitig alle Latche der zweiten Staffelebene LVL1 (bzw.Schiebedimension DII) in die Kaskadenschiebekettengruppen der ersten Staffelebene LVL0 (bzw. Schiebedimension DI) übernommen, und zwar jeweils in eine Latchposition. So wird zum Beispiel der Inhalt von 200 von LT4 in KSG0-1, der Inhalt von 201 von LT4 in KSGO-2 und schließlich der Inhalt von 906 in LT4 von KSG7-7 übernommen.

Nach insgesamt achtmaligem Ausführen dieses achtteiligen Zeitdiagramms werden alle Latche der ersten Staffelebene LVL0 (bzw. Schiebedimension DI) gesetzt. Damit sind auch alle Latche der gesamten Staffelanordnung neu gesetzt, da die Latche der zweiten LVL1 (DII) und dritten Ebene LVL2 (Schiebedimension DIII) auch Bestandteil der ersten Staffelebene LVL0 (bzw. Schiebedimension DI) sind. Das auch hier noch fehlende letzte Latch 907 der dritten Staffelebene LVL2 (bzw. Schiebedimension DIII) kann dann direkt über den Schiebedateneingang SH-I gesetzt werden.

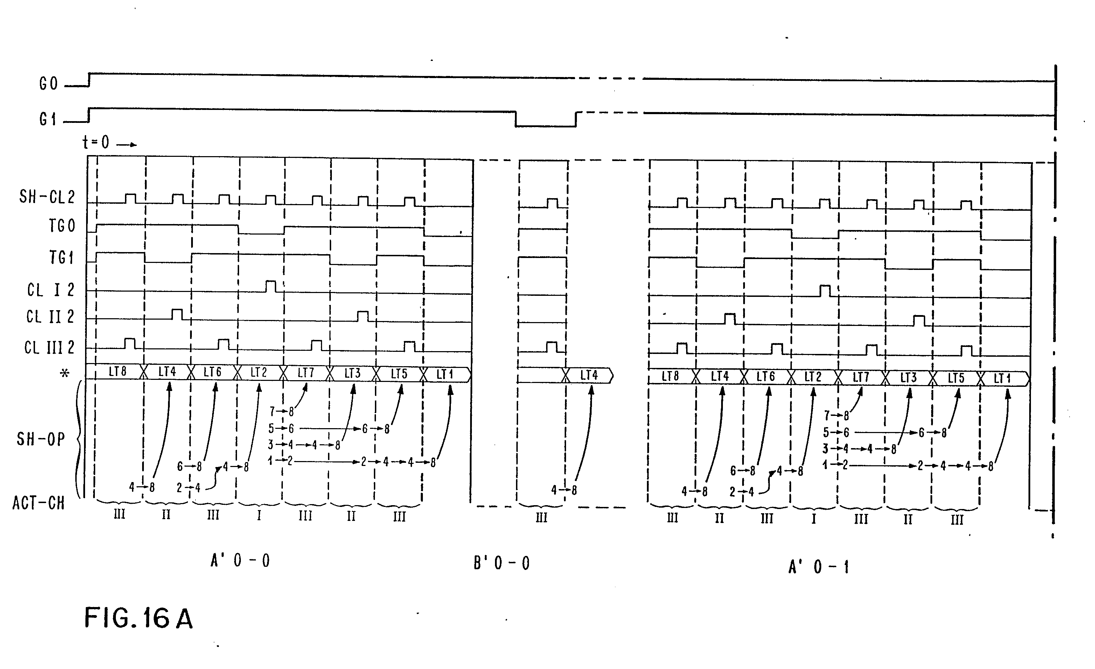

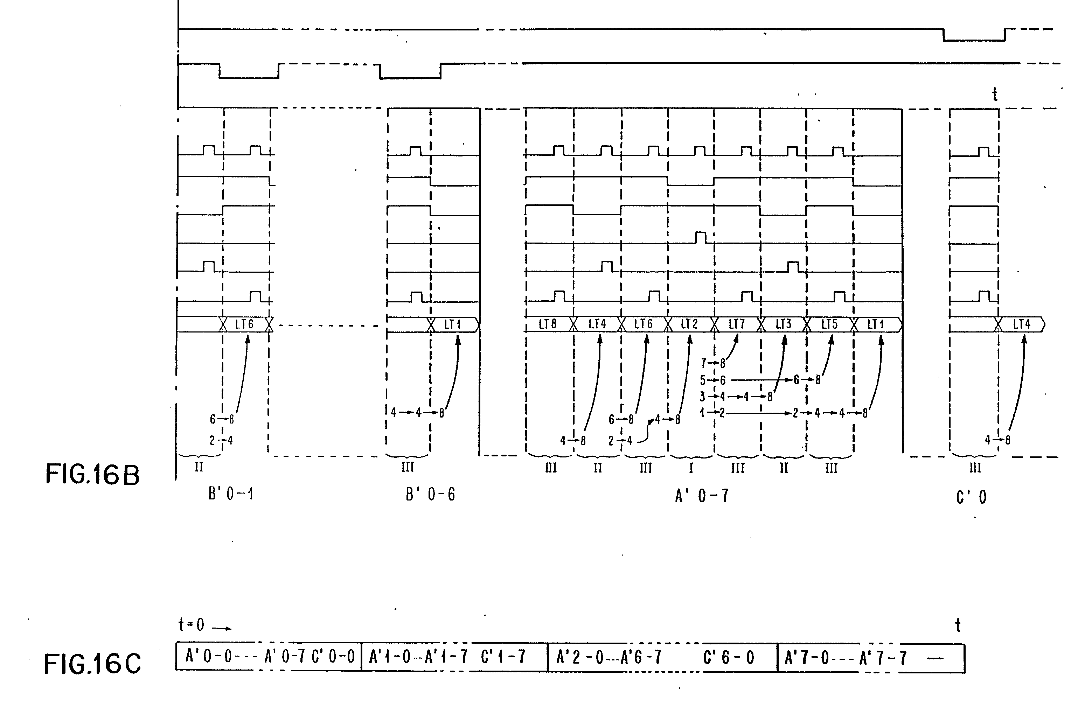

Das Auslesen oder Hinausschieben von Information aus der Anordnung nach Figur 14 erfolgt an Hand des in Figur 16 bzw. 16a dargestellten Zeitdiagramms, das ebenfalls wieder in der Form mehrteiliger Teilzeitdiagramme abgebildet ist. Als erstes wird die Verbindungskaskadenkettengruppe CH 0-LVL2 der dritten Staffelebene (bzw. Schiebedimension DIII) gemäß dem Teilzeitdiagramm A'0-0 hinausgeschoben.

Danach werden die Inhalte der Latche aus den Verbindungskaskadenkettengruppen CH 0-LVL1 der zweiten Staffelebene LVL1 (bzw. Schiebedimension DII) in die Latche der Verbindungskaskadenkettengruppe CH 0-LVL2 gesetzt, und zwar durch Hinausschieben um eine Latch-Position mit Hilfe des Teilzeitdiagramms B'0-0.

Durch siebenmaliges Wiederholen dieser Prozedur (achtmaliges Ausführen) werden alle Latche der ersten Verbindungskaskadenkettengruppen CH 0-LVL1 ausgelesen. Danach werden die Inhalte der Latche aus den Kaskadenschiebekettengruppen der ersten Staffelebene (Schiebedimension DI) in die Verbindungskaskadenkettengruppe CH 0-LVL1 gesetzt, und zwar mit Hilfe des Teilzeitdiagramms C'0.

Auch hier werden durch insgesamt achtmaliges Ausführen dieses achtteiligen Zeitdiagramms alle Latche der Staffelanordnung ausgelesen.

Zu den Figuren 14A, B ist anzumerken, daß dort im wesentlichen die Gruppe 3. Ordnung GRIII im Detail dargestellt wurde. Auch hier ist beispielsweise eine Organisation von acht solcher Gruppen möglich, so daß die in den Figuren 15C und 16C dargestellten Verschiebeabläufe für das Laden bzw. Entladen der gesamten Struktur insgesamt achtmal ausgeführt werden müssen.

Figur 14C ist eine Darstellung der Anordnung nach den Figuren 14A, B, die einen besseren Überblick über deren Organisation gibt und einen Zusammenhang zu den in den Patentansprüchen gewählten Bezeichnungen herstellt.

In dieser Figur 14C entsprechen den Kaskaden-Schiebekettengruppen KSGi die Gruppen erster Ordnung GRI mit jeweils der Länge a, angegeben als Anzahl der Latche in einer solchen Gruppe und der Anordnung von acht Kaskaden-Schiebekettengruppen KSG0-i bis KSG7-i, es entspricht ferner der Gruppe zweiter Ordnung GRII die zweidimensionale Struktur a mal b, wobei b die Anzahl der Schiebekettengruppen (also 8) in dieser Struktur ist.

Die letzten Latche 207, 307, 407, 507, 607, 707, 807 und 907 aller zweidimensionalen Gebilde ergeben zusammengeschaltet eine Schiebekette der Länge c, im vorliegenden Falle ebenfalls 8. Hieraus läßt sich nun eine dreidimensionale Struktur a mal b mal c bilden, die eine Gruppe dritter Ordnung GRIII darstellt.

Die Verschiebeoperationen finden bei einem dreidimensionalen Gebilde a mal b mal c in drei Schiebedimensionen DI, DII und DIII statt, wobei die Verschiebung längs a der Schiebedimension DI, die Verschiebung längs b der Schiebedimension DII und die Verschiebung längs c der Schiebedimension DIII entspricht.

## Ansprüche

1. Anordnung für einen externen Testzugriff auf die chipinternen funktionellen Speicherelemente (2, LTi; Figur 4) hochintegrierter logischer Netzwerke, wobei die Speicherelemente zu linearen Schiebestrukturen gleicher oder verschiedener Längen (a, b, c; Figur 14C) zusammengeschaltet sind, gekennzeichnet durch eine Verbindung von a funktionellen Speicherelementen (2) zu linearen Schiebestrukturen in Gruppen erster Ordnung (GRI) in einer ersten Schiebedimension (DI), durch eine b-malige Wiederholung dieser Gruppen erster Ordnung und Zusammenschaltung der jeweils letzten Speicherelemente (LT8) der Gruppen erster Ordnung zu einer linearen Schiebestruktur, einer zweiten Schiebedimension (DII), wobei diese (a mal b)-Anordnungen die Gruppen zweiter Ordnung (GRII) bilden, durch eine c-malige Anordnung dieser Gruppen zweiter Ordnung und Zusammenschaltung der jeweils letzten Speicherelemente (207, 307, 407, 507, 607, 707, 807, 907) der Gruppen zweiter Ordnung zu einer linearen Schiebestruktur einer dritten Schiebedimension (DIII) wobei diese (a mal b mal c)-Anordnungen die Gruppen dritter Ordnung (GRIII) bilden, durch ggf. weitere Anordnungen, bis insgesamt die gewünschte Anzahl (a mal b mal c mal ...) von zugreifbaren Speicherelementen zusammengeschaltet ist und schließlich durch eine Schiebesteueranordnung (10, 10a, CL-DRi), die mit den Schiebetakteingängen der Speicherelemente verbunden ist, an welche Schiebesteueranordnung Schiebetakte (SH-CL1, SH-CL2) und Selektionssignale (TGi, Gi) anlegbar sind, welch letztere bestimmen, in welcher Schiebedimension (Di) Schiebeoperationen (SH-OP) jeweils dadurch stattfinden, daß die Schiebetakte denjenigen Speicherelementen zugeführt werden, deren Schiebedimension selektiert ist.

2. Anordnung nach Anspruch 1, dadurch gekennzeichnet, daß bei einem internen Aufbau der linearen Schiebestruktur als konventionelle Schiebekette, mit einem Master-/Slave-Latch-Paar je funktionelle Speichereinheit, die verschiedenen Längen (a, b, c ...) beliebige, ganzzahlige, unabhängige Werte annehmen.

3. Anordnung nach Anspruch 1, dadurch gekennzeichnet, daß bei einem internen Aufbau der linearen Schiebestruktur als Imaginär-Schiebekette die verschiedenen Längen (a, b, c ...) einen Wert annehmen, der durch die Anzahl (1 bis 1/2 $^x$ (a, b, c ...) der in der Imaginärschiebekette gewählten Slave-Latche teilbar ist.

4. Anordnung nach Anspruch 1, dadurch gekennzeichnet, daß bei einem internen Aufbau der linearen Schiebestruktur als Kaskaden-Schiebekette die verschiedenen Längen (a, b, c ...) einen Wert $2^k$ mit k = 1, 2, 3 ... annehmen.

5. Verfahren zum Hineinschieben von Information in die funktionellen Speicherelemente (2, LTi) einer Anordnung nach Anspruch 1, gekennzeichnet durch folgende sequentielle Verfahrensschritte:

1 Hineinschieben von Information über die Schiebedatenleitung (SH-I) in die funktionellen Speicherelemente der linearen Schiebestruktur der höchsten Schiebedimension (DN),

2 Weiterschieben dieser Information in die Speicherelemente aller linearen Schiebestrukturen der nächstniedrigeren Schiebedimension (D(N-1)) in jeweils ein Speicherelement jeder dieser linearen Schiebestrukturen,

3 Wiederholung der Schritte 1 und 2 bis zum vollständigen Laden der Speicherelemente der linearen Schiebestrukturen der letztgenannten Schiebedimension (D(N-1)),

4 Weiterschieben dieser Information nach Schritt 2 für die nächstniedrigere Schiebedimension (D(N-2)),

.

(2N-1) Wiederholung der Schritte 1 bis 2N-2 zur vollständigen Ladung aller funktionellen Speicherelemente der Anordnung.

6. Verfahren zum Hinausschieben der Information aus den funktionellen Speicherelementen (2, LTi) über die Schiebedatenleitung (SH-0) einer Anordnung nach Anspruch 1, gekennzeichnet durch folgende sequentielle Verfahrensschritte:

1 Hinausschieben der Information aus den funktionellen Speicherelementen der linearen Schiebestruktur der höchsten Schiebedimension (DN) auf die Schiebedatenleitung (SH-0),

2 Nachschieben der Information aus jeweils einem Speicherelement aller linearen Schiebestrukturen der nächstniedrigeren Schiebedimension (D(N-1)) in die im vorhergehenden Schritt 1 freigewordenen Speicherelemente,

3 Wiederholung der Schritte 1 und 2 bis zum vollständigen Auslesen der Speicherelemente der linearen Schiebestrukturen der letztgenannten Schiebedimension (D(N-1)),

4 Nachschieben der Information nach Schritt 2 aus der nächstniedrigeren Schiebedimension (D-(N-2)),

.

.

.

(2N-1) Wiederholung der Schritte 1 bis 2N-2 zum vollständigen Auslesen aller funktionellen Speicherelemente der Anordnung.

FIG.1

FIG.3

FIG. 2 A

FIG. 2 B

FIG. 4

FIG.5

FIG. 6

FIG. 7

KSG 0

FIG. 8

FIG.9A

0 240 578

KSG 7

| A LT 1 | A LT 2 | A LT 3 | A LT 4 | A LT 5 | A LT 6 | A LT 7 | A LT 8 |
|---|---|---|---|---|---|---|---|
| A | A A | A | A A A A | A | A A A | A | A A A A A A |
| 117 | | 87 | 97 | | 107 | 77 | |

64

CLII1    CLI 2

CLIII 1    CLII 2    CLI 1

CLIII 2

A

65

SL    ○ SH-0

FIG. 9 B

FIG.10 A

KSG 0 — KSG 7

KSG 0 — KSG 7

1. 2. 3. 4. 5. 6. 7. 8.

LT 3 (80) | LT 4 (97) | LT 4 (90) | LT 8 (50) | LT 8 (52) | LT 8 (54) | LT 8 (56) | LT 8 (58) | LT 8 (60) | LT 8 (62) | LT 8 (64)

7 - 4

64 → 50 | 62 → 50 | 60 → 50 | 58 → 50 | 56 → 50 | 54 → 50 | 52 → 50 | 50 → 50
50 → 52 | 52 → 54 | 54 → 56 | 56 → 58 | 58 → 60 | 60 → 62 | 62 → 64

II  0  III  0

**FIG.10 B**

M — GE 984 025

FIG.11A

0 240 578

iM — GE 984 025

0 240 578

**FIG.11 B**

FIG.12

FIG.13

FIG.14 A

FIG. 14B

FIG.14C

iM — GE 984 025

0 240 578

G 0

G 1

t=0

SH-CL 1

TG 0

TG 1

CL I 1

CL II 1

CL III 1

*

LT 7 | LT 3 | LT5 | LT 1 | LT 6 | LT 2 | LT4 | | LT 7 | | LT 7 | LT 3 | LT5 | LT 1 | LT 6 | LT 2 | LT4 | | LT 3

SH-OP

7→4  3→2  5→4  1→1  6→4  2→2  4=4  7→4  7→4  3→2  5→4  1→1  6→4  2→2  4=4  7→4  3→2
      4→6        2→3              4=6              4→6        2→3              4→6
                 3=3                                          3=3
                 4→5                                          4→5
                 5→5                                          5→5
                 6→7                                          6→7
                 7→7                                          7→7

ACT-CH

LVL 2 | = | = | = | 6→7 | = | LVL 2 | LVL 1 | LVL 2 | = | = | = | 6→7 | = | LVL 2 | LVL 1

III | II | III | I | III | II | III | III | III | II | III | I | III | II | III | II

A 0 - 0         B 0 - 0         A 0 - 1         B 0 - 1

FIG.15 A

0 240 578

t

LT 7 · LT 3 · LT5 · LT 1 · LT 6 · LT 2 · LT4 · LT4 · LT 7 · LT 3 · LT 5 · LT 1 · LT 6 · LT 2 · LT4 · LT 7

7→4 · 3→2 4→6 · 5→4 · 1→1 2→3 3→3 4→5 5→5 6→7 7→7 · 6→4 · 2→2 4→6 6→6 · 4→4 · 2→2 4→6 6→6 · 4→4

7→4 · 3→2 4→6 · 5→4 · 1→1 2→3 3→3 4→5 5→5 6→7 7→7 · 6→4 · 2→2 4→6 6→6 · 4→4 · 7→4

LVL2 · = · = · = · = · LVL2 · LVL1 · LVL2 · = · = · = · = · LVL2 · LVL0

III · II · III · I · III · II · III · III · III · II · III · I · III · II · III · III

A 0 - 6     B 0 - 6     A 0 - 7     C 0

# FIG. 15 B

t = 0 ⟶          t

| A0 - 0 --- A0-7   C0-0 | A1 - 0 -- A1-7   C1 - 0 | A2 - 0 --- A2 - 7     C 6 - 0 | A7 - 0 --- A7 - 7    — |

# FIG. 15 C

FIG.16 A

0 240 578

0 240 578

**FIG.16B**

LT6    LT1    LT8 LT4 LT6 LT2 LT7 LT3 LT5 LT1    LT4

7→8
5→6          6→8
3→4→4→8
1→2                2→4→4→8

6→8     4→4→8        6→8     4→8
2→4            4→8    2→4

4→8                        4→8

II          III          III  II  III  I  III  II  III          III

B' 0−1      B' 0−6              A' 0−7              C' 0

**FIG.16C**

t=0 ⟶                                                    t

| A' 0-0 - - - A' 0-7 C' 0-0 | A' 1-0 - A' 1-7  C' 1-7 | A' 2 - 0 --- A' 6-7     C' 6-0 | A' 7-0 --- A' 7-7    — |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| Y | EP-A-0 037 900 (ROCKWELL INTERNATIONAL CORP.) * Figur 13; Seite 15, Zeile 1 - Seite 16, Zeile 21 * | 1 | G 01 R 31/28 G 06 F 11/26 G 11 C 19/00 |
| A | | 5,6 | |
| | --- | | |
| Y | EP-A-0 146 645 (IBM DEUTSCHLAND GmbH) * Ansprüche 1,2; Seite 11, Zeile 9 - Seite 13, Zeile 19; Figuren 2,5 * | 1 | |
| A | | 2 | |
| | --- | | |
| A | US-A-3 766 534 (BEAUSOLEIL et al.) * Figur 2; Spalte 1, Zeile 60 - Spalte 2, Zeile 11; Spalte 4, Zeile 42 - Spalte 5, Zeile 4; Spalte 24, Zeilen 14-63 * | 1 | RECHERCHIERTE SACHGEBIETE (Int. Cl.4) G 01 R 31/28 G 06 F 11/26 G 11 C 19/00 H 03 M 9/00 |
| A,D | EP-A-0 046 499 (IBM DEUTSCHLAND GmbH) * Figur 2; Zusammenfassung * | 3 | |
| | --- | | |
| A,D | EP-A-0 046 500 (IBM DEUTSCHLAND GmbH) * Figur 2; Zusammenfassung * | 4 | |
| | ----- | | |

Der vorliegende Recherchenbericht wurde für alle Patentansprüche erstellt.

| Recherchenort DEN HAAG | Abschlußdatum der Recherche 04-11-1986 | Prüfer HERREMAN,G.L.O. |
|---|---|---|